# EUROPEAN PATENT APPLICATION

(11) **EP 4 832 741 A2**
(43) Date of publication of application: **28.10.2026**
(21) Application number: 26197643.5
(22) Date of filing: 10.08.2026
(51) Int. Cl.: H10W 46/00, G03F 9/00, H10P 72/50

(54) **A SENSOR SYSTEM, A METHOD OF OPERATING A SENSOR SYSTEM AND A BONDING APPARATUS**

(71) Applicant: ASML Netherlands B.V., 5500 AH Veldhoven (NL)
(72) Inventor: HESP, Niels Caspar Herman, 5500 AH Veldhoven (NL); DE WIT, Johannes Matheus Marie, 5500 AH Veldhoven (NL); BEUKMAN, Arjan Johannes Anton, 5500 AH Veldhoven (NL)
(74) Representative: ASML Netherlands B.V.

(57) **Abstract**

The present disclosure relates to a sensor system comprising an illumination branch, a detection branch, and a camera. The illumination branch is configured to illuminate an alignment field comprising an metrology structure on a substrate and to project a pattern onto the substrate at a pattern region outside the alignment field, the pattern being projected at an oblique angle relative to an optical axis of the sensor system. The detection branch is configured to collect light returned from the alignment field and from the pattern region. The camera is configured to acquire a single image comprising an alignment image region representing the metrology structure and a focus image region representing the pattern, the focus image region being spatially separated from the alignment image region. The present disclosure further relates to a method of operating a sensor system.

## Description

### FIELD OF THE INVENTION

The present invention relates to methods and apparatuses used in semiconductor device manufacturing, in particular methods and apparatuses used in bonding of substrates. The present invention also relates to sensor systems for alignment and focus measurements and methods of measuring alignment and focus simultaneously.

### BACKGROUND

In semiconductor device manufacturing processes, apparatuses are used to process substrates and assess and measure characteristics of these processed substrates. A non-limitative example of such an apparatus is a lithographic apparatus for patterning a photosensitive layer (photoresist) provided to a substrate, typically a wafer. Other non-limitative examples of such apparatuses are: a track system for providing the photoresist to the substrate and develop the photoresist, a deposition apparatus for providing the materials to the substrate needed for building semiconductor devices on the substrate, an etching apparatus for patterning the substrate or materials deposited thereon, a Chemo Mechanical Polishing (CMP) apparatus for grinding and polishing a substrate, and an (nano-) imprint apparatus for creating a pattern in a material deposited on a substrate.

In addition to the mentioned apparatuses for processing on a per substrate basis, also tools for bonding a substrate to another substrate are increasingly used. One of the substrates or both substrates used for a bonding process may be processed and/or patterned before. The tools are generally referred to as bonding apparatuses and are configured to bond substrates to substrates, for example, either to bond wafers to each other or to bond dies cut, "diced", from a wafer to another wafer, or to bond dies to dies. After bonding of the substrates, post-bonding processing steps, which may include lithography, may need to be performed to finalize manufacturing of the semiconductor devices.

Currently substrate to substrate bonding is widely used in manufacturing semiconductor devices. A short, non-exhaustive, overview of some important applications is given below:
1) Backside Power Net Delivery (BSPDN) involves creating power distribution networks on the backside of semiconductor wafers. This technique helps in reducing power delivery noise and improving the overall power efficiency of the device. The process involves bonding of a device wafer to a carrier wafer, and then the backside of the device wafer is processed to create the power distribution network.
2) 3D NAND technology uses vertical stacking of memory cells to increase storage density. This is achieved by bonding multiple layers of memory cells together to form a single, high-density memory chip. Hybrid bonding, which involves bonding wafers with exposed metal connections, is commonly used in 3D NAND technology to ensure strong mechanical and electrical connections. High Bandwidth Memory and High Bandwidth Flash are other examples where several dies with memory modules may be stacked by means of hybrid bonding and where the stack may be bonded on an acceptor substrate.
3) Backside Illuminated (BSI) sensors are used in imaging applications, such as digital cameras and smartphones. In BSI sensors, the photodiodes are located on the backside of the wafer, allowing more light to reach the sensor and improving image quality. The manufacturing process involves bonding a device wafer to a transparent carrier wafer, thinning the device wafer, and then processing the backside to create the photodiodes.
4) Integration of different logic circuits: Complex systems are built by combining several different logic circuits that comprise a sub-system as, for example, a specific processor core (e.g. CPU, GPU), a specific type of memory and interfaces to the outside world. These sub-systems are manufactured in different manufacturing processes on substrates which are diced into dies. On an acceptor substrate other logic circuits are manufactured and the dies with the sub-systems are bonded onto this acceptor wafer with hybrid bonding to form the complex system.

The apparatuses and tools mentioned so far have a direct relation with the formation of the semiconductor devices. However other processing tools are involved in the semiconductor manufacturing process as well. These processing tools may be used to create the right conditions for the apparatuses mentioned earlier to function satisfactorily. Non-limitative examples of such tools are tools for cleaning the substrates in preparation of bonding them, activating surfaces of the substrates (plasma based) in preparation of bonding the surfaces, tools for dicing the substrate (wafer) as a preparation for packaging or bonding and a wide range of tools providing thermal treatment of the substrates, such as Post-Exposure Bake and various annealing steps, for example to create a permanent bond between two substrates.

After or during the semiconductor manufacturing process it is standard practice to assess substrates for process control reasons with an assessment apparatus. For example, one assessment may be done using an inspection apparatus to detect defects that may be present in or on the substrate, and another assessment may be done using a metrology apparatus to measure a parameter of interest such as critical dimension, edge placement error (EPE), placement errors and/or overlay. Defects may refer to an error or an imperfection on the product itself which has been patterned, imprinted or processed (e.g., by deposition, or by etching) during the semiconductor device manufacturing processes. The results of the assessments and/or measurements may then be used to monitor or control the semiconductor manufacturing process.

In a bonding apparatus, a donor substrate is positioned relative to an acceptor substrate before the substrates are bonded. To achieve a desired positional relationship between corresponding structures of the substrates, a level of an alignment mark and a position of an alignment mark may be measured. It is to be noted that the level of an alignment mark may represent a distance from the surface of the alignment mark towards for example a sensor that measures the level. The alignment mark may be present on the donor substrate, on the acceptor substrate, or on each of the donor substrate and the acceptor substrate. The measured position of the alignment mark may be used to determine a lateral position of the corresponding substrate, while the measured level may indicate a height or focus condition at or near the alignment mark. If the alignment mark is not measured in focus, the determined position may have an error.

Conventionally, the position of an alignment mark may be measured using an alignment sensor, while the level at or near the alignment mark may be measured using separate level-sensing equipment or in a separate measurement operation. However, separate measurements may require additional measurement equipment, calibration, and measurement time. Moreover, a difference between the location or time at which the level is measured and the location or time at which the position is measured may reduce the extent to which the measured level represents the focus condition during the position measurement. Accordingly, there is a need in the art for accurately determining the level and position of an alignment mark in a bonding tool while limiting equipment complexity and measurement time.

### SUMMARY

According to an aspect of the present disclosure, a sensor system comprises an illumination branch configured to illuminate an alignment field comprising an metrology structure, for example a metrology mark, an alignment structure or alignment mark, on a substrate and to project a pattern, for example a focus pattern, onto the substrate at a pattern region outside the alignment field. The pattern region may be a focus region. The pattern being projected onto the substrate at an oblique angle relative to an optical axis of the sensor system. The sensor system further comprises a detection branch configured to collect light returned from the alignment field and light returned from the pattern region, and a camera optically coupled to the detection branch and configured to acquire a single image comprising an alignment image region representing the metrology structure and a focus image region representing the pattern, the focus image region being spatially separated from the alignment image region.

According to some embodiments, the illumination branch may comprise a field stop configured to shape light used to illuminate the alignment field and to shape light used to project the pattern.

According to some embodiments, the illumination branch may comprise a first light source configured to provide light for illuminating the alignment field and a second light source configured to provide light for projecting the pattern.

According to some embodiments, the detection branch may comprise a pupil filter provided at a pupil plane or a conjugate pupil plane of the detection branch.

According to some embodiments, the camera may be a two-dimensional camera configured to record a two-dimensional image.

According to some embodiments, the sensor system may further comprise a processor configured to process the single image to determine positional information of the metrology structure and to determine a distance value representative of a distance from the sensor system to the substrate.

According to another aspect of the present disclosure, a method of operating a sensor system comprises illuminating an alignment field comprising an metrology structure on a substrate; projecting a pattern onto the substrate at a pattern region outside the alignment field, the pattern being projected at an oblique angle relative to an optical axis of the sensor system; collecting light returned from the alignment field and light returned from the pattern region; and acquiring a single image comprising an alignment image region representing the metrology structure and a focus image region representing the pattern, the focus image region being spatially separated from the alignment image region.

According to another aspect of the present disclosure, a bonding apparatus for bonding a first substrate to a second substrate comprises the sensor system described herein. The sensor system illuminates the alignment field on one of the first substrate and the second substrate and projects the pattern onto the same one of the first substrate and the second substrate. The bonding apparatus further comprises a positioning module for positioning the first substrate with respect to the second substrate and bonding the first substrate to the second substrate.

According to another aspect of the present disclosure, an exposure apparatus for exposing a substrate comprises the sensor system described herein.

According to some embodiments, a semiconductor device manufacturing method may comprise a method of bonding a first substrate to a second substrate. The method of bonding comprises operating the sensor system described herein, illuminating the alignment field on one of the first substrate and the second substrate, projecting the pattern onto the same one of the first substrate and the second substrate, and bonding the first substrate to the second substrate.

According to another aspect of the present disclosure, a computer program product comprises instructions which, when executed by a processor, cause a sensor system to carry out the method of operating the sensor system described herein, the method of bonding the first substrate to the second substrate described herein, or the semiconductor device manufacturing method described herein.

According to another aspect of the present disclosure, a semiconductor device is manufactured by the semiconductor device manufacturing method described herein.

According to another aspect of the present disclosure, a semiconductor device is manufactured using the bonding apparatus described herein, the exposure apparatus described herein, or a cluster system comprising the bonding apparatus or the exposure apparatus.

The spatial separation between the alignment image region and the focus image region allows alignment information and focus information to be acquired in the single image with limited interference between the respective image regions. Projection of the pattern at the oblique angle allows a change in the distance from the sensor system to the substrate to produce a displacement of the pattern in the single image. The field stop allows light for illuminating the alignment field and light for projecting the pattern to be shaped in the illumination branch, and the first light source and the second light source allow light for the respective functions to be provided separately. The pupil filter allows pupil-domain filtering of the collected light, including dark-field filtering of light associated with the alignment image region. The two-dimensional camera allows the spatially separated alignment image region and focus image region to be recorded in the two-dimensional image. The processor allows the positional information and the distance value to be determined from the same single image, thereby improving spatial and temporal correspondence between the position measurement and the distance measurement. In the bonding apparatus and the semiconductor device manufacturing method, the positional information and the distance value can support positioning of the first substrate with respect to the second substrate before bonding. In a bonding apparatus, the determined distance value can be used to correct the positional information, for example, in case that the metrology structure in the alignment field is not measured in focus. In the exposure apparatus, the sensor system can provide alignment and focus information for the substrate. Also in an exposure apparatus, the distance value can be used to correct the obtained positional information.

### BRIEF DESCRIPTION OF THE DRAWINGS

Embodiments of the invention will now be described, by way of example only, with reference to the accompanying schematic drawings, in which corresponding reference symbols indicate corresponding parts, and in which:
- Figure 1 depicts a schematic overview of a hybrid bonding process;
- Figure 2 depicts a flow chart of a hybrid bonding process;
- Figure 3 schematically depicts a non-limitative example of a layout of a bonding apparatus;
- Figure 4 schematically depicts a non-limitative example of a layout of an alternative bonding apparatus;
- Figure 5 shows a schematic view of a sensor system for illuminating an alignment field and projecting a focus pattern;
- Figure 6 schematically shows a field plane layout with a focus pattern arranged outside an alignment field;
- Figure 7 shows a schematic single image comprising spatially separated alignment image and focus image regions;
- Figure 8 shows a schematic optical architecture of an embodiment of the sensor system;
- Figure 9 shows a schematic optical architecture of another embodiment of the sensor system;
- Figure 10 shows a flowchart of a method of operating a sensor system; and
- Figure 11 schematically shows an exposure apparatus.

The features shown in the Figures are not necessarily to scale, and the size and/or arrangement depicted is not limiting. It will be understood that the Figures include optional features which may not be essential to the invention. Furthermore, not all of the features of the apparatus are depicted in each of the Figures, and the Figures may only show some of the components relevant for describing a particular feature.

### DETAILED DESCRIPTION

The term "substrate" as employed in this text may be broadly interpreted as referring to an object on which a pattern may be created. Non-limitative examples include a semiconductor substrate and a substrate made of other, non-semiconductor material (e.g. a glass or quartz substrate). The semiconductor substrate may be a wafer, such as a silicon wafer or germanium wafer, for example or a portion of a wafer, such as a die, for example. For the purposes of the present disclosure, a substrate as referred to above may be considered as a non-limitative example of an object intended for use in an apparatus used in semiconductor device manufacturing.

A semiconductor device made from a substrate may have various device elements. Non-limitative examples of semiconductor device elements that are formed over the substrate include transistors (e.g., planar or non-planar metal oxide semiconductor field effect transistors, bipolar junction transistors, high-voltage transistors, high-frequency transistors, etc.), diodes, CMOS image sensors, passive devices, and/or other applicable elements. Various processes may be performed to form the semiconductor device elements, such as lithography, (nano-) imprint, deposition, etching, implantation, epitaxial growth, polishing, thermal treatment, bonding, and/or other suitable processes.

To form some types of semiconductor device, one semiconductor substrate (which has circuit features, or at least one integrated circuit element or device, formed thereon) may be bonded with another semiconductor substrate. Bonding processes include die-to-die (D2D), die-to-wafer (D2W) and wafer-to-wafer (W2W) bonding processes. W2W bonding, where whole wafers are permanently bonded together prior to dicing, has the potential of providing a high throughput bonding solution. D2W bonding involves the bonding of individual dies to a location on a wafer, wherein the individual dies are obtained by dicing a wafer into dies. This D2W bonding process allows for multiple (different) dies to be bonded onto a single wafer. In D2D bonding, similar dies, or different dies, are bonded on top of each other. Similar dies may refer to dies with similar bonding surfaces being bonded to each other. That is, the areas where the bonding process occurs are similar in both dies to be bonded. Likewise, different dies may refer to dies with different bonding surfaces. That is, the areas where the bonding process occurs may have different sizes in the dies to be bonded.

Substrates that already comprise device components are often referred to as "donor" substrates (either wafers or dies), while the substrate receiving the donor substrate is often referred to as the "acceptor" substrate (either wafer or die). In some cases, the acceptor substrate may also comprise device components. In some cases, the receiving substrate is also referred to as the "carrier wafer" in case the acceptor substrate is a wafer which serves to provide a basis for the donor substrate (either a die or wafer).

In particular, for W2W bonding, two main types of bonding can be discerned: fusion and hybrid bonding. Fusion bonding is used for example in manufacturing of BSI sensors and the BSPND, while hybrid bonding is typically used in manufacturing devices that are distributed across two separate substrates, such as 3D NAND devices.

In a fusion bonding process a donor wafer is flipped and subsequently bonded to a carrier substrate, wherein the patterned surface of the donor wafer is normally the bonding surface of the donor wafer. After bonding the backside of the donor wafer is thinned down from some mm's to only about 100µm or even less, while being supported by the thicker carrier substrate bonded to it. The backside of the donor wafer then may serve as the substrate for subsequent semiconductor manufacturing processing steps, such as lithography, etching, deposition, CMP, (nano-) imprint, and the like.

Fusion bonding enables permanent connection via dielectric surfaces on each of the donor and acceptor substrates and provides a good bonding strength with a high bonding yield. The dielectric surfaces may comprise, for example, silicon oxide, e.g. activated silicon oxide of the form SiOxHy. Additionally or alternatively, the dielectric layers may comprise, for example, SiON, e.g. activated SiON of the form SiOxNyHz. The activation of the silicon oxide or the SiON may comprise plasma activation or activation comprising use of a hydrogen radical generator. Typically, a fusion bonding process comprises three main steps: 1) surface preparation which may include surface planarization, cleaning and activation; 2) pre-bonding at room temperature which may include aligning the two bonding surfaces relative to each other and bringing the aligned substrates in contact with each other to obtain an initial bonding strength; and 3) annealing (or heat treatment) at elevated temperatures (e.g., 150°C to 500°C) to fix the bond and achieve the high bonding strength. In the fusion bonding process, adhesion of the two bonding surfaces occurs at room temperature via van der Waals forces between the two bonding surfaces and via hydrogen bridge bonds of chemisorbed water molecules - resulting in an initial bonding strength. The hydrogen bridge bonds of chemisorbed water molecules may react during the annealing step to form covalent siloxane bonds to achieve the final high bonding strength. The spontaneous adhesion of the two bonding surfaces (e.g. through van der Waals forces and the like) may be referred to as optical bonding. Further information about the fusion bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.
A hybrid bonding process differs from the fusion bonding process in that both substrates to be bonded are provided with patterns related to the semiconductor devices. Hence both the donor and acceptor substrates comprise patterns of different materials and care must be taken to accurately align them in order for the patterns to have a correct positional relationship to enable, for example, electrical contact.

From a technical process perspective, a hybrid bonding process combines fusion bonding and metal diffusion bonding into a single bonding process and enables simultaneous formation of dielectric-to-dielectric and metal-to-metal bonds between the bonding surfaces of the two substrates. The metal-to-metal bonds between the two substrates may provide one or both of: (a) increased bond strength between the two substrates; and (b) electrical connection between the two substrates (e.g. electrical connection between a functional device formed on one substrate and another functional device formed on another substrate).

In a hybrid bonding process, metal connections are embedded in bonding surfaces of the substrates that are to be bonded together. The metal may be copper, gold, or any other metal or metal alloy with a coefficient of thermal expansion that is greater than the coefficient of thermal expansion of the material from which the dielectric layer is formed. The metal connections may be embedded in the dielectric layer of the substrates that are to be bonded together. The metal connections may be in the form of a plurality of metallic portions (which may be referred to as metallic pads, or more commonly as "bond pads") distributed across at least part of the substrate surface (e.g. distributed across at least part of the dielectric layer of the substrates). For example, the bond pads may be formed by etching the dielectric layer on the substrate (e.g., to create vias to the metal below) and electroplating (or electrochemical deposition) at least part of the etched dielectric layer to form the bond pads therewithin. It is to be noted that the surface with the bond pads may comprise bond pads that are electrically connected with the circuitry of the substrate and that there may be bond pads that are not electrically connected to the circuitry. Design rules which guarantee the manufacturability of the patterns may define a requirement for a regular grid of bond pads. The bonding surface of a substrate may also be referred to as a joining surface of the substrate.

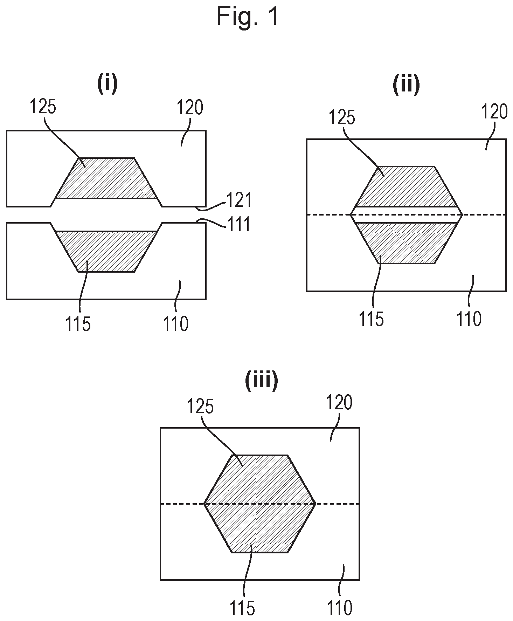

Similar to the fusion bonding process, the hybrid bonding process also comprises the following three main steps: 1) surface preparation which may comprise cleaning the surface, activating the surface and/or hydrating the surface; 2) pre-bonding at room temperature; and 3) annealing (or heat treatment) at elevated temperatures. Steps (2) and (3) are schematically depicted in Figure 1, which depicts a metallic portion 115 in a first substrate 110 and a metallic portion 125 in a second substrate 120. The single metallic portion on each of the first and second substrate 110, 120 is shown to explain the hybrid bonding process, and is representative of a plurality of metallic portions 125.

At stage (i) in Figure 1, a bonding surface 111 of the first substrate 110 is separated (e.g. spaced apart, no physical contact) from a bonding surface 121 of the second substrate 120. The bonding surface 111 of the first substrate 110 may be formed at least partially by a dielectric layer. The metallic portion 115 may be recessed below the bonding surface 111, but exposed, in other words, unveiled at the bonding surface 111 (e.g. not covered by the dielectric layer). The bonding surface 121 of the second substrate 120 may be formed at least partially by a dielectric layer. The metallic portion 125 may be recessed below the bonding surface 121, but exposed, unveiled, at the bonding surface 121 (e.g. not covered by the dielectric layer).

In the hybrid bonding process, the two substrates 110, 120 may be aligned relative to each other. Then, the two substrates 110, 120 may be moved toward each other such that the dielectric material of the bonding surfaces 111, 121 of the two substrates 110, 120 come into contact, and are bonded together by means of the van der Waals forces. At stage (ii) in Figure 1 the two substrates 110, 120 have been brought into contact with one another. At this point in the process, the metallic portion 115 of the first substrate 110 may not be bonded to (or in contact with) the metallic portion 125 of the second substrate 120. This may be because the metallic portions 115, 125 are recessed below the respective bonding surfaces 111, 121, as described above. By recessing the metallic portions 115, 125 below the respective bonding surfaces 111, 121, the metallic portions 115, 125 do not interfere with the initial bonding that occurs between the (dielectric) bonding surfaces 111, 121.

At stage (iii) in Figure 1, the two substrates 110, 120 have been subjected to an annealing (or heat treatment) step. As described above, the annealing (or heat treatment) converts hydrogen bridge bonds into covalent siloxane bonds. Further, the heating of the metallic portions 115, 125 causes the metallic portions 115, 125 to expand up to or beyond the level of the respective bonding surfaces 111, 121. Thus, the metallic portions 115, 125 contact one another. Where the metallic portions 115, 125 contact one another, metal diffusion bonds may be formed. Further information about the hybrid bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464.

After bonding, the metallic portions 115, 125 may be misaligned. There may be different reasons for this misalignment. The manufacturing process of the metallic portions 115, 125 may have left a fingerprint, or an error, or imperfection, that causes positional deviations of the metallic portions 115, 125. Warpage of or stress in the substrates 110, 120 may also cause positional deviations of the metallic portions 115, 125. Local expansions of the substrate may also cause local positional deviations. Some reasons for the misalignment find their origin outside the bonding process itself and some reasons for the misalignment may be induced by the bonding process itself. For example, as the two semiconductor substrates are brought together during the bonding process, one or both of the semiconductor substrates may become deformed, for example, as a result of clamping and/or the propagation of a bond front during the bonding process itself.

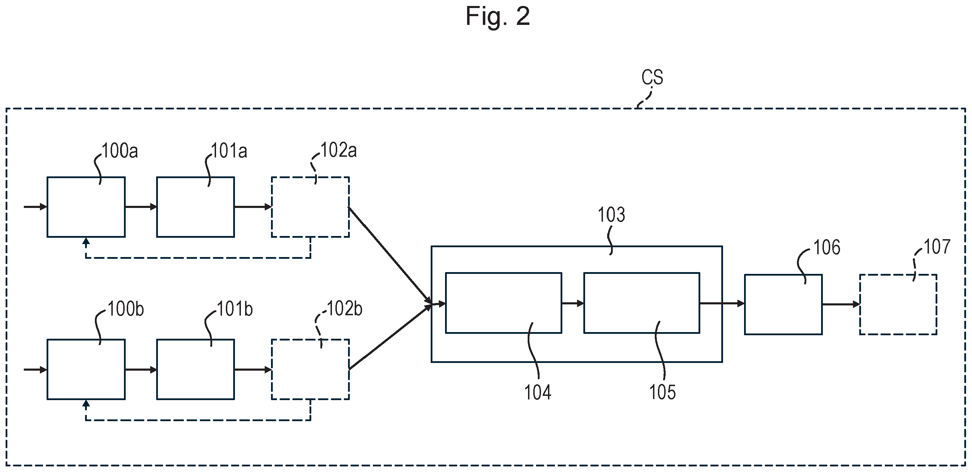

Figure 2 schematically depicts a hybrid bonding process flow. Figure 2 mainly presents the apparatuses that perform certain process steps in the hybrid bonding process flow. A bonding apparatus 103 receives a donor substrate and an acceptor substrate. In an example, the donor substrate is a die - often the term donor die is used. The donor substrate is processed, in preparation for the bonding process, by a cleaning apparatus 100a, by an activation apparatus 101a and optionally by a hydration apparatus (not shown in Figure 2). The bonding apparatus 103 also receives an acceptor substrate. In an example, the acceptor substrate is an acceptor wafer. The acceptor substrate is processed, in preparation for the bonding process, by a cleaning apparatus 100b, by an activation apparatus 101b, and optionally by a hydration apparatus (not shown in Figure 2). It is to be noted that Figure 2 shows two sequences of the cleaning apparatus 100a, 100b and the activation apparatus 101a, 101b. However, it is also possible that the same physical apparatuses are used for preparation of the donor substrate and the acceptor substrate.

The cleaning apparatuses 100a, 100b clean the bonding surface of the donor substrate and/or the acceptor substrate. The cleaning apparatuses 100a, 100b remove undesired particles from the surface and any other material that is undesired. In the example of Figure 1, after cleaning, the bonding surfaces of the substrates only comprise the oxide material and the material of the bond pads. The activation apparatuses 101a, 101b activate the surface to be bonded such that oxide material becomes an activated oxide material, e.g. activated silicon oxide. Examples of activation technology have been discussed above. In certain hybrid bonding process technologies, it is also required to execute a step of surface hydration by a hydration apparatus. The surface hydration may form hydroxyl groups (-OH) at the surface. Subsequently, during bonding, the initial bond strength between the two surfaces will be higher.

The above processes may be followed by an inspection/assessment of the bonding surfaces in a bonding surface assessment apparatus 102a, 102b. The bonding surface assessment apparatuses 102a, 102b may, for example, inspect the bonding surface for particles, contamination, and/or abnormalities. For example, if the bonding surface is not clean enough, a substrate may be sent back to the cleaning apparatuses 100a, 100b. This is represented in Figure 2 as dashed arrows from the bonding surface assessment apparatus 102a to the cleaning apparatus 100a and from the bonding surface assessment apparatus 102b to the cleaning apparatus 100b respectively. The bonding surface assessment apparatuses may also determine a parameter of interest of the bonding surface, e.g. measure the amount of surface activation. If the amount of surface activation is not sufficient, the substrate may be sent back to the activation apparatuses 101a, 101b (not shown in Figure 2). The measured parameters of interest may also be fed forward towards the bonding apparatus 103 such that it can be used by the bonding apparatus 103 as a control parameter. The measured parameters of interest may also be fed back towards another semiconductor manufacturing apparatus involved in the manufacturing of donor substrates and acceptor substrates (not shown in Figure 2). The measured parameters of interest may also be fed forward towards another at least one semiconductor manufacturing apparatus and/or at least one assessment apparatus involved in the semiconductor manufacturing process after bonding (not shown in Figure 2).

In the bonding apparatus 103, there is a first step of positioning 104 the donor substrate with respect to the acceptor substrate. For example, in D2W bonding, the relative position of the acceptor wafer with respect to the donor die ("donor substrate") is controlled such that the donor substrate can be placed on the acceptor wafer at exactly the required position. The bonding apparatus 103 may have a location measurement module, e.g. alignment sensor, which measures the position of marks on the substrates or which measures on-product structures on the substrates.

In a subsequent step the actual bonding 105 happens where the donor substrate is brought in contact with the acceptor substrate. Often there is a single initial point of contact and then an area where the substrates are in contact will increase due to the attractive forces between the bonding surfaces to form the initial bond.

After bonding one or more donor substrates to the acceptor substrate, a bonded combination of acceptor substrate and one or more donor substrates is sent to an annealing apparatus 106. As discussed above, in the annealing apparatus the bonded combination is heated in one or more steps to form the final bond between the materials at the bonding surfaces.

Optionally, the finally bonded combination of acceptor substrate and one or more donor substrates can be sent to a further assessment apparatus 107 to either inspect the bonded combination for abnormalities or measure parameters of interest of the finally bonded combination. For example, it may be assessed whether all donor substrates are indeed bonded at approximately the required location. For example, a post bond overlay error at a specific position between the acceptor substrate and one of the donor substrates may be measured. Output of the assessment apparatus 107 can be used in feedback loops to the bonding apparatus 103 as a control parameter for future bonding steps or fed back or fed forward towards other tools in the semiconductor manufacturing flow. Output of the assessment apparatus 107 can be used in feedback loops as a control parameter of another semiconductor manufacturing apparatus involved in the manufacturing and/or preparation for bonding of donor substrates and acceptor substrates (not shown in Figure 2).

It is to be noted that two or more of the apparatuses 100a-107 of Figure 2 may be combined in a single manufacturing system, such as a cluster system CS or a track. In the cluster system CS or track there is in general an infrastructure available to transport substrates to and from individual apparatuses. It is to be noted that in Figure 2 all apparatuses 100a-107 are part of the cluster system CS or track, while in other embodiments a cluster system CS only comprises a subset of the apparatuses 100a-107.

In an embodiment a cluster system CS is provided for manufacturing a semiconductor device. The cluster system CS may comprise semiconductor processing apparatuses and the bonding apparatus 103 described in this document. There is disclosed a semiconductor manufacturing method comprising the bonding process described in this document. In an additional embodiment, the cluster system may further comprise at least one processing chamber, e.g. cleaning chamber and/or activation chamber, and/or at least one a transport robot that moves the acceptor substrates and the carrier substrates with donor substrates to all the different apparatuses / chambers.

Once bonded, the bonded combination of acceptor substrate and one or more donor substrates may be subject to further lithographic patterning and processing. If, for example, multiple donor substrates are bonded to one acceptor substrate, spaces between the donor substrates may be filled with a suitable material to create a planar top surface.

During the manufacturing of semiconductor devices on the earlier discussed substrates, it is desirable that the process conditions for processing substrates using one or more processing apparatuses remain stable such that values of one or more properties of the features remain within certain control limits. Stability of the process is of particular significance for features of the functional parts of the device, the product features. To help ensure stable processing, process control capabilities should be in place. Process control involves monitoring of processing data and implementation of means for process correction, e.g., controlling the processing apparatus based on characteristics of the processing data. Process control may be based on periodic measurement by at least one metrology apparatus (or any other assessment apparatus), often referred to as "Advanced Process Control" (also referred to as APC). More information on APC can be found in U.S. Patent Application Publication No. US 2012-0008127, which is incorporated herein in its entirety by reference. A typical APC implementation involves periodic measurements on metrology features on the substrates (including bonded substrates) to monitor and correct drifts associated with one or more processing apparatuses. The metrology features reflect the response to process variations of the product features

Non-limitative examples of such apparatuses used in manufacturing of semiconductor devices are a lithographic apparatus, an annealing apparatus, an etching station, an etching apparatus or a bonding apparatus.

Once bonded, the bonded substrate may be subject to further additional semiconductor manufacturing processes. An APC loop may be used for control and to correct any error or fingerprint that the bonded substrate may comprise. The APC loop may be used in any of the semiconductor manufacturing processes. In a non-limitative embodiment, the bonded substrate is passed to a metrology apparatus (or any assessment apparatus) where information relating to a parameter of interest such as a shape, critical dimension, EPE, placement errors, sidewall angles, and/or overlay is determined. This determined value (data) of the parameter of interest is subsequently passed onto an APC module. This data (i.e., information relating to the critical dimensions, sidewall angles, EPE and/or overlay) may also be passed to the lithography apparatus. In a non-limitative example, semiconductor manufacturing process corrections may be determined by the APC module. Depending on the application, those corrections may be sent to an apparatus of the semiconductor manufacturing process in a feedback or feedforward manner. For example. in holistic bonding, if corrections are related to improve the bonding apparatus performance or any pre bonding litho or non-litho process, the corrections may be known as feedback corrections. If the corrections are related to improve any post bonding semiconductor processes (e.g., lithography, etching and/or deposition apparatuses), the corrections may be known as feedforward corrections.

In semiconductor device manufacturing processes, multiple finished or unfinished semiconductor substrates or devices (e.g., whole wafers, diced wafers, partially diced wafers, chips, dies, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple dies, where these specific portions may need to be aligned in three-dimensional space to ensure functional connectivity. Alignment of these dies, which may have multiple fabrication layers, different critical dimensions, different nodes, packaging, etc., with respect to another substrate may require specific alignment methods, probably different from what is typically used for example in lithography during fabrication. As the physical sizes of semiconductor device components continue to shrink, and their structures continue to become more complex, accuracy and throughput in integration become more important. For applications such as heterogeneous integration, it may be desirable to achieve both accurate and fast placement of one substrate with respect to another substrate.

In the semiconductor manufacturing industry tools to place dies on wafers are referred to as D2W bonding apparatuses, in contrast to W2W bonding apparatuses. Generally, these D2W bonding apparatuses comprise a die handling system configured to pick up a donor substrate from a donor carrier and subsequently transport the donor substrate to a target location on the acceptor substrate. The die handling system may comprise a single component that picks up the die and bonds it to the acceptor substrate and in another example, the die handling system may be a sequence of two or more steps of picking up the die and placing it on a temporary location or handing it over to another die handling component and finally placing it on the acceptor substrate. In the bonding apparatus, the carrier may be provided with the dies facing in an upwards direction or with the dies facing in a downwards direction. The acceptor substrate may have the surface to which dies must be bonded facing in an upward direction or alternatively in a downward direction. Depending on the specific configuration in the bonding apparatus, the die handling system may flip the die into another orientation. The actual bonding of the donor substrate to the acceptor substrate is initiated by bringing the donor substrate into contact with the target area on the acceptor substrate while exerting at least a minimum required force. This may further involve slightly bending the donor substrate around its center such that the center of the donor substrate makes first contact with the acceptor substrate. After first contact the bonding process is initiated. The bonding process itself normally evolves as a "bond wave" or "bonding wave" that propagates from the initial point of contact, for example the center of the die, towards all edges of the donor substrate. The bonding wave represents the propagation of a bonded area across the interface of the donor substrate and the acceptor substrate, driven by factors like surface properties, pressure of the environmental gasses (for example, air), and temperature. Understanding and controlling the bonding wave dynamics is important for achieving high-quality, defect-free bonding of dies to acceptor substrates. An alternative term for the "bond wave" is "bond front".

During the transport of the donor substrate towards the acceptor substrate various sensors may be used to ensure accurate alignment and positioning of the donor substrate relative to the acceptor substrate. In some cases, one of the sensors may be part of an image based or diffraction based alignment system. Other sensors may be provided for other types of measurements, such as flatness of the bonding surfaces, height profiles, substrate 3D shape (e.g. substrate warpage), or relative positions of features on the donor substrate with respect to other features on the acceptor substrate.

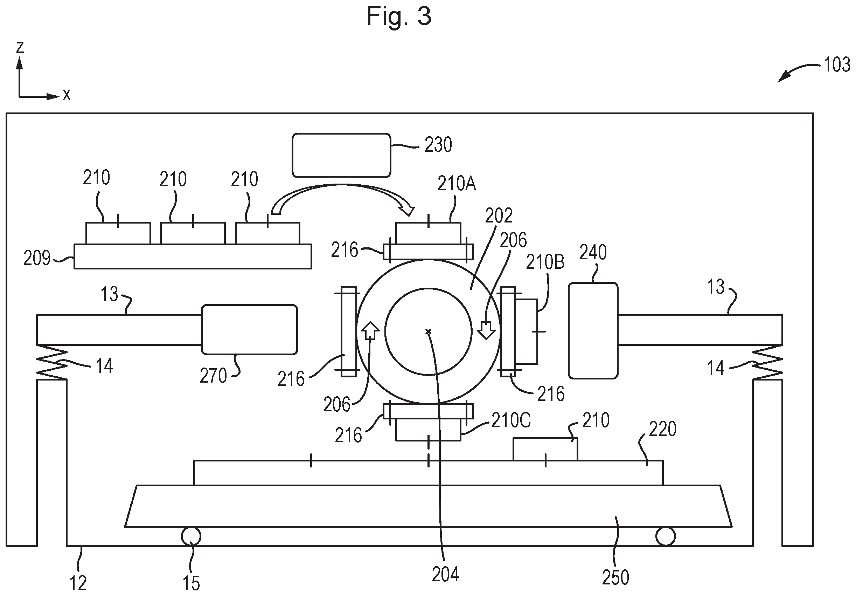

Figure 3 is a schematic drawing illustrating an example of the layout of a high throughput and highly accurate D2W bonding apparatus 103. As explained earlier, dies that are to be bonded to a substrate are referred to as donor substrates, while the substrate receiving the donor substrates is referred to as an acceptor substrate 220 (e.g. a wafer). In the bonding apparatus 103 of Figure 3 placement of donor substrates is performed by a movable positioning module 202 with donor holders 216 configured to hold the dies during the bonding process. Figure 3 is described with reference to a "donor substrate" and a "target die", which are relative descriptors and a donor substrate may instead be a target die and vice versa. Please note that the target die is a die at a target location on an acceptor substrate. Figure 3 is a cross-sectional view of placement of donor substrates 210A-210C using the positioning module 202. The positioning module 202 is substantially circular in the x-z plane, with a longitudinal axis 204 along the y-direction (e.g., the positioning module 202 is substantially cylindrical in three dimensions). The positioning module 202 may instead have a different cross-sectional shape, such as square, hexagonal, etc. The positioning module 202 may have a symmetrical (e.g., as shown) cross-section with one or more axis of symmetry, or asymmetrical cross-sectional area (for example, an irregular polygon).

The positioning module 202 has donor holders 216 capable of accepting and holding donor substrates, such as the donor substrates 210A- 210C. The placement of the donor holders 216 may be symmetrical or asymmetrical around the cross-sectional area of the positioning module 202.

The positioning module 202 may be controllably moved (rotated) in a direction 206 about the longitudinal axis 204. The direction 206 is provided as a non-limitative example. The positioning module 202 may instead be rotated in an opposite direction or any appropriate direction, translated along the x, y, or z direction or any combination thereof. The positioning module 202 may be operated in both rotational and translational modes, including sequentially or at the same time. For example, the positioning module 202 may move in the negative z-direction towards a acceptor holder 250 while also rotating about the longitudinal axis 204. The acceptor holder 250 is configured to support and/or hold an acceptor substrate 220. The positioning module 202 may move continuously or intermittently. For example, the positioning module 202 may rotate in the direction 206 and stop at four (or fewer or more) positions corresponding to operations in the placement of die. Example positions and operations will now be further discussed. These positions and operations are provided as non-limitative examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the positioning module 202 is substantially zero), but the positions may instead correspond to continuous (or quasi-continuous movement) or operations may occur while the positioning module 202 is moving in one or more directions (e.g., rotationally, translationally, etc.).

A first position, such as corresponding to the position depicted for the donor substrate 210A, may correspond to placement of dies on donor holders 216 of the positioning module 202. The donor substrate 210A may be placed on the donor holder 216 by a pick and place module 230. The pick and place module 230 may place the donor substrate 210A on the donor holder 216 based on positional information of the positioning module 202. The pick and place module 230 may place the donor substrate 210A at a given position relative to the donor holder 216. For example, the pick and place module 230 may place the donor substrate 210A substantially centred to the donor holder 216.

A non-limitative additional example of the function of the pick and place module 230 may be the exchange of a donor holder 216. The pick and place module 230 may be configured to exchange a donor holder 216 of the positioning module 202 for a replacement donor holder. The replacement donor holder may be configured to handle donor substrates of a different size than the donor substrates 210A-C handled by the initially used donor holders 216.

The second position, such as corresponding to the position depicted for the donor substrate 210B, may correspond to e.g. measurement of the position of the donor substrate 210B relative to the donor holder 216 or any other position referenced to the positioning module 202. The position (e.g., location) of the donor substrate 210B may be measured by a location measurement module 240. The location measurement module 240 may measure an actual position of the donor substrate 210B, in relative (such as relative to the donor holder 216) or absolute terms (such as in distances from an origin point on the positioning module 202, on the location measurement module 240, etc.). The location measurement module 240 may be a camera, e.g., a two-dimensional camera, two or more one-dimensional cameras, an optical camera, etc., or another measurement device. The location measurement module 240 may be made up of multiple location measurement modules, such as an in-plane measurement device which may measure locations in the y-z plane (relative to the refence axes) and an out of plane measurement device which may measure locations or distances in the x direction (relative to the reference axes). The location measurement module 240 may include one or more confocal microscopes, which may measure depth (or other distance). The location measurement module 240 may measure position, relative or absolute position, using overlay diffraction or other diffraction-based methods. The location measurement module 240 may measure die position information while the donor substrate 210B is moved by the positioning module 202 (e.g. operating in a scanning mode) or while the donor substrate 210B is at a fixed position relative to the positioning module 202 (e.g. operating in a static mode).

The location measurement module 240 may be a diffraction based sensor or an image based sensor. For a diffraction based sensor, the mark or the product structure may be a repetitive structure in one or both of the x dimension and the y dimension. A non-limitative example of a repetitive structure in x and y is the earlier discussed array of bond pads that is present at the bond surface of the acceptor substrate 220 and/or the donor substrate 210. In an image based sensor, a camera creates an image of a structure on the one or more substrates and detects a position of the structure in the image to determine the position of the one or more substrates within the bonding apparatus 103. The structures to be imaged may be structures that are provided specifically for the location measurement, e.g. in an alignment target, or may be a known and/or recognizable product structure. Portions of the array of bond pads may also be used for image based location measurements. If the position of both substrates is accurately known, the bonding apparatus 103 is able to determine the relative position of the donor substrate 210C with respect to the acceptor substrate 220 and is able to position them at an appropriate position with respect to each other.

The location measurement module 240 may also contain other types of measurement equipment beneficial for the bonding process. Alternatively, the bonding apparatus 103 may comprise more positions around the periphery of the positioning module 202 to allow other types of measurement systems or pre-bonding processing systems to interact with the donor substrate 210B.

Once the position of the donor substrate 210B is measured or other measurements or pre-bonding processing has been performed, the positioning module 202 may move (e.g., in the direction 206), so that the donor substrate 210B occupies the position of the donor substrate 210C which may be a third position of the positioning module 202 in the current example embodiment. The third position of the acceptor holder 250 will now be described with reference to the donor substrate 210C.

The third position, such as corresponding to the position depicted for the donor substrate 210C, may correspond to placement of the die on a corresponding target location, for example an acceptor substrate 220. The acceptor substrate 220 may comprise one or more donor substrates 210. These one or more donor substrates 210 have been bonded previously to the acceptor substrate 220. In between bonding different donor substrates 210, 210C, the positioning module 202 moves such that the donor substrate 210C is opposite the corresponding target location on the acceptor substrate 220.

The acceptor substrate 220 is supported by the acceptor holder 250. The donor substrate 210C may be placed on the acceptor substrate 220 by motion of the positioning module 202 towards the acceptor substrate 220. Alternatively or additionally, the acceptor holder 250 may also be operable to bring, or contribute to bringing, the donor substrate 210C and the acceptor substrate 220 into contact. Other terms used for the acceptor holder may be substrate clamp, substrate stage or substrate table. In so far as the substrate is a wafer, the acceptor holder may also be referred to as wafer clamp, wafer stage or wafer table.

Once the donor substrate 210C is placed on the acceptor substrate 220, the positioning module 202 and the acceptor holder 250 may operate (individually or in concert) to place additional donor substrates on the acceptor substrate 220. For example, the acceptor holder 250 may move in the negative x-direction so that another part of the acceptor substrate 220 is proximate to the positioning module 202 and a next donor substrate (for example, the donor substrate 210B after rotation of the positioning module 202) may be placed on the acceptor substrate 220. The relative motion of the positioning module 202 and the acceptor holder 250 may occur in any appropriate direction. A direction of gravity is not depicted, but the placement of the donor substrate 210C on the acceptor substrate 220 may experience gravitation effects. For example, the placement of the donor substrate 210C on the acceptor substrate 220 may be encouraged by gravity (e.g., occur in the direction of gravity) or be retarded by gravity (e.g., occur opposite the direction of gravity). Gravitational effects may be balanced by die clamps, suction, vacuum, or other forces such as electrostatic or capillary forces.

The positioning module 202 shown in Figure 3 is for die placement. The positioning module 202 is for placing donor substrates 210, for example onto an acceptor substrate 220. The positioning module 202 comprises an actuator system. The actuator system is configured to cause the positioning module 202 to accept the donor substrates 210 from the pick and place module 230 and subsequently transport the donor substrates 210 to the location measurement module 240, such as for example an alignment sensor and finally place the donor substrates 210 on the acceptor substrate 220.

As shown in Figure 3, the bonding apparatus 103 may comprise one single positioning module 202. The positioning module 202 may place donor substrates 210 onto the acceptor substrate 220 sequentially. In an alternative embodiment, the bonding apparatus 103 may comprise a plurality of positioning modules 202. The positioning modules 202 may be configured to operate in parallel. The positioning modules 202 may be configured to place a plurality of donor substrates 210 onto the acceptor substrate 220 substantially simultaneously. In an embodiment not shown in Figure 3, the donor holder 216 is configured to hold a plurality of donor substrates 210 and therefore, the bonding apparatus is configured to bond a plurality of donor substrates 210.

As shown in Figure 3, the bonding apparatus 103 may comprise one single pick and place module 230. The pick and place module 230 may be configured to pick and place donor substrates 210 sequentially. The pick and place module 230 may be configured to pick a plurality of donor substrates 210. The pick and place module 230 may be configured to place one or more donor substrates 210 onto the positioning module 202. Alternatively, the bonding apparatus 103 may comprise a plurality of pick and place modules 230. The pick and place modules 230 may be configured to pick a plurality of donor substrates 210 substantially simultaneously. The pick and place modules 230 may be configured to place a plurality of donor substrates 210 simultaneously.

The pick and place module 230 may be configured to pick a donor substrate 210 from a first location of the donor carrier 209 and place it at a second location of the donor carrier 209. Subsequently, the same or another pick and place module 230 may be configured to pick the donor substrate 210 from the second location and place it on the positioning module 202.

As shown in Figure 3, the acceptor substrate 220 may be supported by an acceptor holder 250 configured to move the acceptor substrate 220, e.g. at high accuracy. A controller may be implemented to control the positioning module 202 and the acceptor holder 250 to accurately place the donor substrate 210 from the donor carrier 209 to the acceptor substrate 220.

As shown in Figure 3, the bonding apparatus 103 may comprise a base frame 12. As shown in Figure 3, the acceptor holder 250 that supports the acceptor substrate 220 may be coupled to the base frame 12 by at least one bearing 15. The acceptor holder 250 may further comprise a plurality of modules that may be stacked relative to each other via a plurality of bearings (not shown). For example, the acceptor holder 250 may comprise a long stroke module (not shown) for relatively coarse positioning of the acceptor substrate 220 over a longer distance, and a short stroke module (not shown) for higher accuracy positioning of the acceptor substrate 220 over a shorter stroke.

As shown in Figure 3, the bonding apparatus 103 may comprise a reference frame 13. The reference frame 13 may be referred to as an isolated frame. The reference frame 13 may be isolated relative to the base frame 12. For example, as shown in Figure 3, the bonding apparatus 103 may comprise an isolator 14. The isolator 14 is configured to substantially isolate the reference frame 13 from the base frame 12. By isolating the reference frame 13 from the base frame 12, vibrations of the base frame 12 may have less effect on the reference frame 13. For example, measurements of the location of a donor substrate 210B may be made relative to the reference frame 13 to achieve higher accuracy measurements because of the reduction of vibrations compared to when the location measurement module 240 would be connected to the base frame 12.

As shown in Figure 3, the bonding apparatus 103 may further comprise an inspection module 270 which may be in contact with the reference frame 13, or alternatively, in contact with the base frame 12. The inspection module 270 may inspect, for example, an opposite donor holder 216 to check whether a donor substrate 210 is present at the donor holder 216 or not. Non-limitative additional examples of a function of the inspection module 270 may be detecting particles on or abnormalities of the surface of the donor holder 216.

The acceptor holder 250 of Figure 3 may be a movable stage, typically driven by one or more Lorentz actuators. The position of the acceptor holder 250 may be continuously monitored by a position measurement system. The position measurement data may be used as input for a controller of the Lorentz actuators. The position measurement system may comprise an interferometer system configured to measure the distance of the acceptor holder 250 with respect to a reference, for example the base frame 12 or the reference frame 13. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror may be connected to the acceptor holder 250. The reference mirror may be connected to the reference frame 13. The measurement beam and the reference beam may be combined into a combined radiation beam by an additional optical component instead of the beam splitter. Other types of position measurement systems, for example encoder based position measurement systems may also be used to monitor the position of the acceptor holder 250. A combination of encoders and interferometers may also be used in a positioning measurement system. The position measurement systems may measure the position of the acceptor holder 250 with respect to a reference location in the bonding apparatus 103, for example, with respect to the reference frame 13 or the base frame 12.

It is to be noted that, in line with the above paragraph, the position of the positioning module 202 might also be measured with respect to a reference within the bonding apparatus 103 by a position measurement system.

In addition to a configuration with a single acceptor holder 250 for supporting, holding and transporting the acceptor substrate 220 also configurations with multiple acceptor holders may be applicable, for example, multiple acceptor wafer stages. D2W bonding apparatuses may have two or more acceptor holders 250. In such "multiple stage" D2W bonding apparatuses, the acceptor holders 250 may be used in parallel, and/or during steps in preparation of bonding a donor substrate 210 to the acceptor substrate 220. This multi-stage architecture enables for example performing metrology measurements on a first acceptor substrate, while being held on a first acceptor holder being located at a specific measurement location. At the same time a second acceptor substrate may be held by a second acceptor holder being at a location where a donor substrate is to be bonded to the second acceptor substrate. In this particular configuration the productivity of the D2W bonding process is enhanced as required pre-bonding metrology measurements can be scheduled in parallel to the bonding of donor substrates to its corresponding acceptor substrate. The results of the pre-bond metrology measurements on the first acceptor substrate may then be used in a subsequent step of bonding donor substrates to said first acceptor substrate. The latter further implies that the D2W bonding apparatus comprises multiple measurement modules, such as a first alignment sensor configured to perform the pre-bond alignment measurements and a second alignment sensor being used during alignment of the acceptor substrate while it receives the donor substrates.

Although not shown in Figure 3, in an embodiment the bonding apparatus 103 comprises separate compartments for picking donor substrates 210 and for bonding donor substrates 210. For example, the bonding apparatus 103 may comprise a picking compartment in which the pick and place module 230 picks donor substrates 210 from the donor carrier 209. The bonding apparatus 103 may comprise a bonding compartment in which the positioning module 202 bonds donor substrates 210 to the acceptor substrate 220. The pick and place module 230 may be configured to transfer donor substrates 210 from the picking compartment to the bonding compartment.

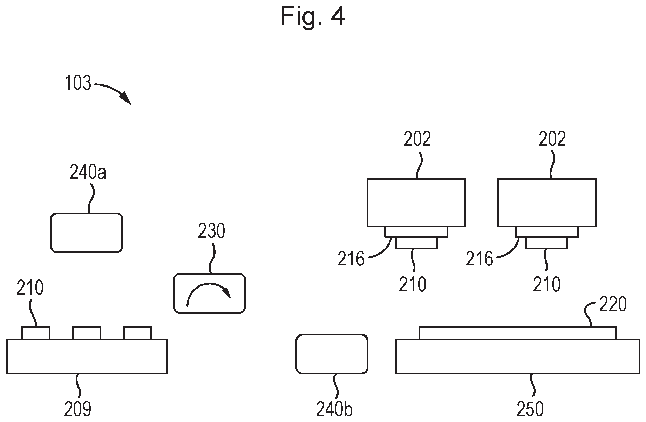

Figure 4 schematically depicts a non-limitative example of a layout of an alternative D2W bonding apparatus 103. As shown in Figure 4, the bonding tool 103 may comprise a first location measurement module 240a. The first location measurement module 240a may be configured to measure a location of one or more donor substrates 210 on the donor carrier 209. The first location measurement module 240a may be a camera facing towards the donor carrier 209. The first location measurement module 240a may be configured to measure a location of a component of the pick and place element 230. The pick and place element 230 may comprise a mark to facilitate measurement of the location of the component by the first location measurement module 240a.

The first location measurement module 240a may be configured to measure a location of the acceptor substrate 220 and/or the acceptor holder 250. For example, the first location measurement module 240a may be configured to measure a mark on the acceptor holder 250 and/or a mark on the acceptor substrate 220. The first location measurement module 240a may be configured to measure a location of the acceptor substrate 220 relative to the acceptor holder 250. That is, the first location measurement module 240a may be configured to measure alignment of the acceptor substrate 220 relative to the acceptor holder 250. The acceptor holder 250 may move relative to the first location measurement module 240a such that the first location measurement module 240a can measure the marks on the acceptor holder 250 and the acceptor substrate 220. The first location measurement module 240a may be configured to measure alignment of the acceptor substrate 220 relative to the acceptor holder 250 before the donor substrates 210 are bonded to the acceptor substrate 220.

The first location measurement module 240a may comprise an assessment apparatus configured to measure a level, flatness, height profile and/or 3D shape (e.g., warpage) of an object to be measured, for example the donor substrates 210 on the donor carrier 209. An example of such apparatus is a level sensor. Additionally or alternatively, the first location measurement module 240a may comprise a further assessment apparatus configured to measure alignment of an object to be measured, for example the acceptor substrate 220 and the acceptor holder 250. An example of such apparatus is an alignment sensor. The first location measurement module 240a may be mounted to a frame of the bonding apparatus 103, for example a reference frame of the bonding apparatus 103.

In an embodiment the pick and place module 230 is configured to flip the donor substrate 210. By flipping the donor substrate 210, the pick and place module 230 puts the donor substrate 210 into the orientation for bonding. The pick and place module 230 may comprise a gripper or collet for gripping the donor substrate 210 and an arm configured to pivot to flip the gripper. The pick and place module 230 may be configured to move translationally. The pick and place module 230 may be configured to move in six degrees of freedom. The pick and place module 230 may hand over the flipped donor substrate 210 to the positioning module 202.

Although not shown in Figure 4, in an embodiment the bonding apparatus 103 comprises separate compartments for picking donor substrates 210 and for bonding donor substrates 210. For example, the bonding apparatus 103 may comprise a picking compartment in which the pick and place module 230 picks donor substrates 210 from the donor carrier 209. The bonding apparatus 103 may comprise a bonding compartment in which the positioning module 202 bonds donor substrates 210 to the acceptor substrate 220. The pick and place module 230 may be configured to transfer donor substrates 210 from the picking compartment to the bonding compartment.

As shown in Figure 4, the bonding apparatus 103 may comprise a second location measurement module 240b. The second location measurement module 240b may be configured to measure a location of a donor substrate 210 on the positioning module 202. The second location measurement module 240b may be configured to measure a location of the positioning module 202. The positioning module 202 may comprise a mark to facilitate measurement of the location of the positioning module 202 by the second location measurement module 240b.

The second location measurement module 240b may comprise a level sensor configured to measure a level, flatness, height profile and/or 3D shape (e.g., warpage) of the object to be measured, for example the donor substrates 210 on the positioning module 202. The second location measurement module 240b may comprise an alignment sensor configured to measure alignment of the object to be measured, for example the alignment of the donor substrates 210 relative to the positioning module 202. The acceptor holder 250 may move relative to the positioning module 202 such that the second location measurement module 240b can measure the mark on the positioning module 202 and the donor substrates 210. The alignment of the donor substrates 210 relative to the positioning module 202 may be measured before the donor substrates 210 are bonded to the acceptor substrate 220.

The second location measurement module 240b may be configured to measure alignment of the positioning module 202 relative to the acceptor holder 250. For example, the second location measurement module 240b may comprise a further alignment sensor for measuring alignment of the positioning module 202 relative to the acceptor holder 250. The further alignment sensor may comprise the mark on the acceptor holder 250 that is measured by the first location measurement module 240a. Alternatively, the alignment sensor for measuring alignment of the donor substrates 210 relative to the positioning module 202 may be further configured to measure alignment of the positioning module 202 relative to the acceptor holder 250. The second location measurement module 240b may measure alignment of the positioning module 202 relative to the acceptor holder 250 by measuring a plurality of marks on the positioning module. The acceptor holder 250 may move relative to the positioning module 202 such that the second location measurement module 240b can measure the marks on the positioning module 202. The alignment of the positioning module 202 relative to the acceptor holder 250 may be measured before the donor substrates 210 are bonded to the acceptor substrate 220.

The positioning module 202 may be configured to move translationally, for example to align the donor substrate 210 to a target location of the acceptor substrate 220. The positioning module 202 may be configured to move in six degrees of freedom. Additionally or alternatively, the acceptor holder 250 may be configured to move translationally to align the target location to the donor substrate 210. The acceptor holder 250 may be configured to move in six degrees of freedom. The positioning module 202 may be fixed translationally to a frame of the bonding apparatus 103. For example, the positioning module 202 may be mounted to the same frame to which the first location measurement module 240a is mounted.

The positioning module 202 may be configured to move the donor substrate 210 towards the acceptor substrate 220. The positioning module 202 may comprise at least one donor holder 216 configured to hold at least one substrate 210 during the bonding process. The positioning module 202 may place the donor substrate 210 onto the acceptor substrate 220 for bonding. For example, the positioning module 202 may actuate the donor substrate 210 substantially perpendicularly to the acceptor substrate 220 to place the donor substrate 210 onto the acceptor substrate 220.

As shown in Figure 4, the donor carrier 209 may be located such that the donor substrates 210 are substantially coplanar with the acceptor substrate 220 or donor substrates 210 bonded to the acceptor substrate 220. In an alternative embodiment, the donor carrier 209 may be elevated relative to the acceptor substrate 220, for example as shown in Figure 3.

As shown in Figure 4, the donor carrier 209 may be oriented to carry the donor substrates 210 such that their bonding surfaces face substantially the same direction as the bonding surface of the acceptor substrate 220. In an alternative embodiment, the donor carrier 209 may be configured to carry the donor substrates 210 such that their bonding surfaces face the opposite direction. For example, the donor carrier 209 may be configured to carry the donor substrates 210 upside down relative to what is shown in Figure 4. The pick and place module 230 may not be required to flip donor substrates 210 picked from the donor carrier 209. The donor carrier 209 may be held by a carrier support. The carrier support may be mounted to a frame of the bonding apparatus 103. The positioning module 202 may be mounted to the same frame of the bonding apparatus 103. The carrier support and/or the positioning module 202 may be movable along the frame.

As shown in Figure 4, the bonding apparatus 103 may comprise one single pick and place module 230. The pick and place module 230 may be configured to pick and place donor substrates 210 sequentially. Alternatively, the bonding apparatus 103 may comprise a plurality of pick and place modules 230. The pick and place modules 230 may be configured to pick a plurality of donor substrates 210 substantially simultaneously. The pick and place modules 230 may be configured to place a plurality of donor substrates 210 simultaneously. The pick and place modules 230 may be configured to move relative to each other, for example to controllably adjust a pitch between the pick and place modules 230. The arrangement (for example, the pitch) of the pick and place modules 230 may be controlled to match the arrangement of donor substrates 210 on the donor carrier 209 to be picked.

In a further alternative embodiment, the pick and place module 230 may be omitted. For example, the positioning module 202 may pick the donor substrates 210 directly from the donor carrier 209. The donor carrier 209 may be moved such that the positioning module 210 can pick the donor substrates 210 from the donor carrier 209. The donor carrier 209 may be supported by the long stoke module of the acceptor holder 250. The long stroke module may be configured to move the donor carrier 209 relative to the positioning module 202 such that the positioning module 202 can pick the donor substrates 210 sequentially from the donor carrier 209.

As shown in Figure 4, in an embodiment the bonding apparatus 103 comprises a plurality of positioning modules 202. The positioning module 202 may comprise at least one donor holder 216 configured to hold at least one substrate 210 during the bonding process. The positioning modules 202 may be configured to place a corresponding plurality of donor substrates 210 onto the acceptor substrate 220 substantially simultaneously. The positioning modules 202 may also be configured to place a corresponding plurality of donor substrates 210 onto the acceptor substrate 220 sequentially. The arrangement (for example, the pitch) of the pick and place modules 230 may be controlled to match the arrangement of positioning modules 202 onto which the donor substrates 210 are to be placed. In an alternative embodiment, the bonding apparatus 103 may comprise one single positioning module 202. The donor substrates 210 may be placed onto the acceptor substrate 220 sequentially by means of this single positioning module 202.

In an alternative embodiment, the positioning module 202 comprises a plurality of individually actuatable elements configured to actuate respective donor substrates 210 perpendicularly to the donor carrier 209 (during picking) or acceptor substrate 220 (during bonding). The individually actuatable elements may be substantially translationally fixed relative to each other, while allowing substantially independent actuation perpendicular to the donor carrier 209 (during picking) or acceptor substrate 220 (during bonding). For example, the positioning module 202 may comprise a housing to which the individually actuatable elements are mounted. The housing may be mounted to a frame of the bonding apparatus 103, for example the same frame to which the first location measurement module 240a is mounted. The acceptor holder 250 may move the acceptor substrate 220 relative to the positioning module 202 such that the positioning module 202 can place the donor substrates 210 sequentially onto respective target locations of the acceptor substrate 220.

Although not shown in Figure 4, the bonding apparatus 103 may comprise another location measurement module configured to measure a location of one or more donor substrates 210 held by the pick and place module 230. For example, the location of a flipped donor substrate 210 on the pick and place module 230 may be measured before the donor substrate 210 is handed over to the positioning module 202. In an alternative embodiment, this measurement of the donor substrate 210 held by the pick and place module 230 may be performed by the second location measurement module 240b.

Although not shown in Figure 4, the bonding apparatus 103 may comprise another location measurement module configured to measure a location of the acceptor substrate 220 and/or the acceptor holder 250. The acceptor holder 250 may comprise a mark to facilitate measurement of the location of the acceptor substrate 220 and/or the acceptor holder 250. The location measurement module may also measure a mark on the acceptor substrate 220.

The acceptor holder 250 may comprise a long stroke module (not shown) for relatively coarse positioning of the acceptor substrate 220 over a longer distance, and a short stroke module (not shown) for higher accuracy positioning of the acceptor substrate 220 over a shorter stroke. Although not shown in Figure 4, the pick and place module 230 may be mounted to the acceptor holder 250. For example, the pick and place module 230 may be mounted to the long stroke module of the acceptor holder 250 (or another carriage of the acceptor holder 250). The acceptor substrate 220 maybe mounted to the short stroke module, which may be mounted to the long stroke module. Relative movement between the acceptor holder 250 and the positioning module 202 may be controlled to align the pick and place module 230 with the positioning modules 202. This may facilitate the donor substrates 210 being handed over from the pick and place module 230 to the positioning modules 202. Alternatively, movements of the pick and place module 230 may be independent of the acceptor holder 250.

Although not shown in Figure 4, the second location measurement module 240b may be mounted to the acceptor holder 250. For example, the pick and place module 230 may be mounted to the long stroke module of the acceptor holder 250 (or another carriage of the acceptor holder 250). Relative movement between the acceptor holder 250 and the positioning module 202 may be controlled to facilitate measurement of alignment between the acceptor holder 250 and the positioning modules 202. Alternatively, the location of the second location measurement module 240b may be independent of movement of the acceptor holder 250. The second location measurement module 240b may even be stationary.

The bonding apparatus 103 described with reference to Figure 3 or Figure 4 may be configured to pick a plurality of donor substrates 210 from the donor carrier 209 in parallel, and to bond a plurality of donor substrates 210 to the acceptor substrate 220 in parallel. Alternatively, the bonding apparatus 103 may be configured to pick a plurality of donor substrates 210 from the donor carrier 209 in series, and to bond a plurality of donor substrates 210 to the acceptor substrate 220 in parallel. Alternatively, the bonding apparatus 103 may be configured to pick a plurality of donor substrates 210 from the donor carrier 209 in series, and to bond a plurality of donor substrates 210 to the acceptor substrate 220 in series. Alternatively, the bonding apparatus 103 may be configured to pick a plurality of donor substrates 210 from the donor carrier 209 in parallel, and to bond a plurality of donor substrates 210 to the acceptor substrate 220 in series.

An example bonding process is described. The bonding process may comprise loading the acceptor substrate 220 onto the acceptor holder 250. The bonding process may comprise loading the donor carrier 209 into position for picking. For example, the donor carrier 209 may be loaded onto the long stroke module of the acceptor holder 250. The donor carrier 209 may have the donor substrates 210 loaded onto it before the donor carrier 209 is loaded into position. Alternatively, the donor substrates 210 may be loaded onto the donor carrier 209 after the donor carrier 209 has been loaded into position.

The bonding process may comprise moving the donor carrier 209 relative to the positioning system 202 such that the positioning system 202 can pick the donor substrates 210. Alternatively, the pick and place module 230 may pick the donor substrates 210 and place them onto the positioning module 202. The donor substrates 210 may be picked sequentially.

The bonding process may comprise aligning the acceptor substrate 220 to the acceptor holder 250. The acceptor holder 250 may move relative to the first location measurement module 240a such that the first location measurement module 240a can measure the alignment of the acceptor substrate 220 relative to the acceptor holder 250.

The bonding process may comprise aligning the acceptor holder 250 to the positioning module 202. The acceptor holder 250 may move relative to the positioning module 202 such that the second location measurement module 240b can measure the alignment of the acceptor holder 250 relative to the positioning module 202.

The bonding process may comprise aligning the donor substrates 210 on the positioning module 202 to the positioning module 202. The acceptor holder 250 may move relative to the positioning module 202 such that the second location measurement module 240b can measure the alignment of the donor substrates 210 on the positioning module 202 relative to the positioning module 202. The alignment of the donor substrates 210 may be measured sequentially. The alignment of the donor substrates 210 may be measured while the donor substrates 210 are at the level they will be actuated to for bonding. For example, the positioning module 202 may actuate the donor substrates 210 towards the acceptor substrate 220 for measuring their alignment. The acceptor holder 250 may move the acceptor substrate 220 away from the positioning module 202 such that the donor substrates 210 remain distanced from the acceptor substrate 220 during measurement of their alignment.

The bonding process may comprise the acceptor holder 250 moving the acceptor substrate 220 such a target location of the acceptor substrate 220 is aligned with a donor substrate 210 on the positioning module 202 to be bonded at the target location. The positioning module 202 may actuate the donor substrate 210 to place the donor substrate 210 at the target location. The donor substrates 210 may be bonded sequentially to respective target locations of the acceptor substrate 220. The acceptor holder 250 may move the acceptor substrate 220 between each donor substrate 210 being bonded, to align the target locations to respective donor substrates 210 on the positioning module 202.

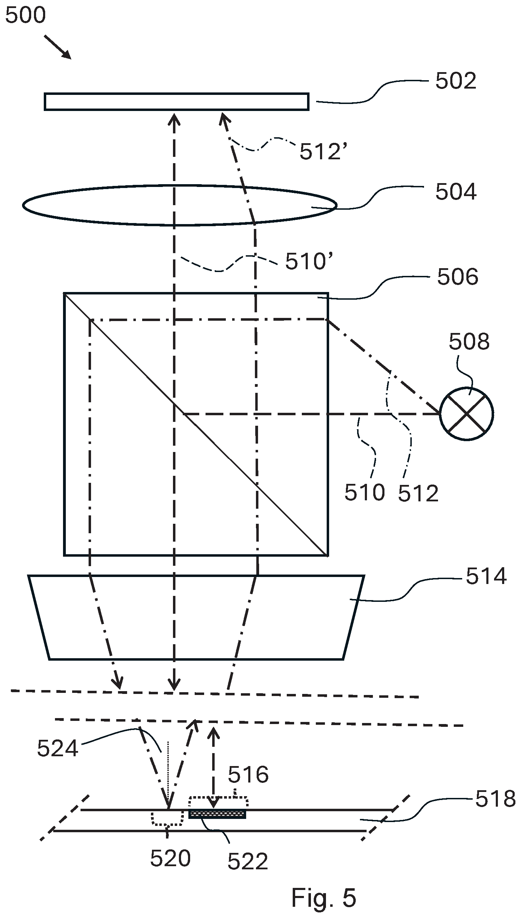

In the subsequent description of figures 5 to 11, one may read, instead of the term 'alignment mark', also read 'metrology structure', instead of 'focus pattern' the general term 'pattern', and instead of 'focus region' it may be 'pattern region'.

As described with reference to FIGS. 1 to 4, bonding a first substrate to a second substrate may involve positioning corresponding structures of the substrates relative to one another before their bonding surfaces are brought together. In the die-to-wafer bonding apparatus embodiments, a donor substrate may be transferred from a donor carrier to a positioning module and positioned relative to a target location on an acceptor substrate supported by an acceptor holder. Accurate positioning may depend on both a lateral position of an alignment mark and a level or focus condition at or near the alignment mark. Defocus, substrate tilt, surface topography, or a spatial or temporal separation between alignment and level measurements may reduce the accuracy with which the donor substrate and the acceptor substrate are positioned. Providing separate alignment and level sensors within the location measurement modules may also increase optical complexity, calibration effort, installation-space requirements, and measurement time.

The bonding apparatus 103 as described herein can be used in a method for manufacturing a semiconductor device. The bonding apparatus 103 can be used to manufacture a semiconductor device by bonding a first semiconductor circuit to a second semiconductor circuit.

In embodiments of the bonding apparatus described with reference to FIGS. 1 to 4, one or more location measurement modules may comprise a sensor system that integrates alignment and focus metrology according to the invention. The sensor system may illuminate an alignment field comprising an alignment mark on the donor substrate, the acceptor substrate, a substrate holder, or another component of the bonding apparatus, and may project a focus pattern at an oblique angle onto a focus region outside the alignment field. Light returned from the alignment field and the focus region may be collected by, for example, an objective and, transmitted via a detection branch towards a camera and recorded in spatially separated regions of a single image. The image may be processed to determine positional information for the alignment mark and a distance value representative of the level or focus condition of the measured object. The resulting positional information and distance value may be used to obtain corrected positional information, and the positional information and/or the corrected positional information may be used to position a donor substrate and/or an acceptor substrate accurately. For example, the positional information and/or corrected positional information is used to position a donor substrate accurately with respect to an acceptor substrate such that the donor substrate can be bonded in an accurate manner to the acceptor substrate. Thereby the bonding apparatus can operate more accurately while reducing the amount of required equipment and measurement time. It is to be noted that a wafer to wafer bonding tool may also have one or more sensor systems to measure an alignment position and a focus level (distance between sensor and surface of wafers). The sensor that is discussed herinafter can also be used in a wafer to wafer bonding tool.

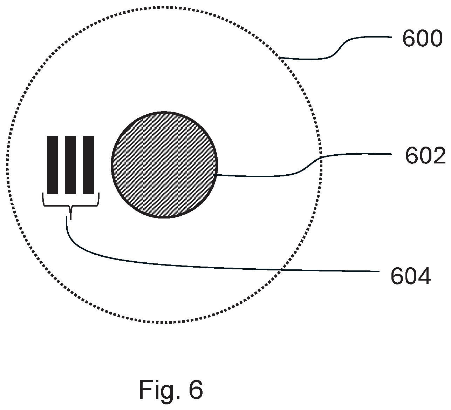

FIG. 5 shows a schematic view of an embodiment of a sensor system 500 configured to obtain alignment information and focus information from a substrate 518. The sensor system 500 comprises a camera 502, a lens 504, a beam splitter 506, a light source 508, and an objective 514. An illumination branch of the sensor system 500 is configured to illuminate an alignment field 516 comprising an alignment mark 522 on the substrate 518 and to project a focus pattern onto the substrate 518 at a focus region 520 outside the alignment field 516. A detection branch of the sensor system 500 is configured to collect light returned from the alignment field 516 and light returned from the focus region 520 and to direct the collected light toward the camera 502. It is to be noted that the bottom part of Fig. 5, which is the part below the slightly diagonal striped lines, is in a real embodiment some distance away from the objective 514. In this schematic image, the bottom part has been zoomed in compared to the scale of the top part of Fig. 5. As it will be seen later, for example in the context of Figure 6, the alignment field 516 and focus region 520 receive light from the illumination branch and an envelope around them has a diameter in the hundreds of micrometers, while, for example, the objective 514 has a diameter in the millimeter or centimeter range.

It is to be noted that the alignment mark 522 is not by definition at the top surface of substrate 518. An alignment mark may also be present in a layer at a certain distance away from the top surface of the substrate 518. For example, certain wavelenghts of light may be transmitted into the substrate 518 and may be diffracted and/or reflected by structures in a layer at a certain depth in the substrate 518. The alignment mark 522 is any structure that is suitable for, and which is used for, determining a position of this mark 522 or structure on the substrate 518. It may also be a recognizable structure on the substrate which is suitable for being imaged on the camera 502. The alignment mark 522 may also be a structure that is specifically manufactured on the substrate 518 for performing alignment / position measurements.

It is to be noted that the focus region 520 may be a larger area. For example, it may be a ring shaped area around the alignment mark 522. In the cross sectional view of Figure 5 this would be a focus region 520 that is at the left and right side of the alignment mark 522.

The light source 508 provides alignment illumination light 510 and focus illumination light 512 to the illumination branch. The focus illumination light 512 is patterned such that, when imaged on the substrate 518, a focus pattern is projected within the focus region 520. The beam splitter 506 directs the alignment illumination light 510 and the focus illumination light 512 toward the objective 514. In the illustrated embodiment, the alignment illumination light 510 propagates substantially along a central optical axis of the sensor system 500, while the focus illumination light 512 propagates off-axis. The objective 514 projects the alignment illumination light 510 onto the alignment field 516 and projects the focus illumination light 512 onto the focus region 520 as the focus pattern. The focus illumination light 512 is incident on the substrate 518 at an angle 524 relative to a direction perpendicular to a surface of the substrate 518. In the illustrated arrangement, the perpendicular direction is substantially parallel to the central optical axis, such that the angle 524 corresponds to an oblique angle relative to the central optical axis.

The objective 514 collects returned alignment light 510' from the alignment field 516 and returned focus light 512' from the focus region 520. A portion of the illumination branch and a portion of the detection branch are combined along a shared optical path through the objective 514 and between the beam splitter 506 and the substrate 518. The illumination branch is formed by the optical path from the light source 508, via the beam splitter 506, the objective 514 towards the substrate 518. The beam splitter 506 directs the returned alignment light 510' and the returned focus light 512' through the lens 504 toward the camera 502. The lens 504 is arranged between the beam splitter 506 and the camera 502 and images the returned alignment light 510' and the returned focus light 512' onto the camera 502. The detection branch is formed by the optical path from the substrate 518, via the objective 514, the beam splitter 506, the lens 504 towards the camera 502.

It is to be noted that the term objective 514 is, in general, a single optical element or a collection of optical elements. It may comprise one or more lenses and it may comprise one or more mirros.

It is to be noted that the beam splitter 506 is an example of an optical element that, on one hand, combines the illumination branch and detection branch towards the objective 514 and the substrate 518, and on the other hand, make sure that another portion of the illumination branch and another portion detection branch are separated. One or more other optical elements may be used to fulfill the same function in the sensor system 500.

In the context of Figure 5, only a central optical axis of the alignment light 510, 510' and a central optical axis of the focus light 512, 512' is drawn by means of, respectively, the dashed / dashed-dotted lines. If, for example, as will be discussed later, the alignment mark 522 is a grating (e.g. a diffractive structure), there will also be first and/or higher diffraction orders that follow a different optical path than the central optical axis.

The camera 502 may be a two-dimensional camera configured to acquire a single image comprising an alignment image region representing the alignment mark 522 and a focus image region representing the focus pattern. In the single image, the focus image region is spatially separated from the alignment image region. A displacement of the focus pattern relative to an expected position within the single image may be used to determine a distance value representative of a distance from the sensor system 500 to the substrate 518. The positional information of the alignment mark 522 and the distance value may thus be determined from the same single image. Optionally, the distance value may be used to correct the positional information, for example, in case the alignment mark was not exactly in the focus of the sensor system 500.

With the sensor system 500 it is possible to determine the positional information and the distance value simultaneously by obtaining the single image. The invention is not limited to determining the values simultaneously. The sensor system 500 can also be used at a first moment to determine the distance value and at another moment to determine positional information. For example, assuming the surface of the substrate 518 is relatively flat, then the sensor system 500 may already determine a distance value while the substrate 518 is moving, assuming the moving will not blur the single image on the camera 502 too much Once the substrate 518 is stanstill, one may obtain e.g. an image of the alignment mark 522.

FIG. 6 shows a schematic example of field of view 600 of the sensor system 500 at the substrate 518. Within the field of view 600, an illumination spot 602 is provided at the alignment field 516 on the substrate 518, and a projected focus pattern 604 is projected at the focus region 520 outside the alignment field 516. The illumination spot 602 may correspond to light used to illuminate the alignment field 516 comprising the alignment mark 522.

In the example of Fig. 6, the illumination spot 602 is circular. In another embodiment, the illumination spot is rectangular or square. In an example, the illumination spot 602 overfills the alignment mark.

The illumination spot 602 and the projected focus pattern 604 are spatially separated within the field of view 600. In the illustrated embodiment, the illumination spot 602 is arranged laterally offset from the projected focus pattern 604, such that light returned from the alignment field 516 and light returned from the focus region 520 can be recorded in respective spatially separated regions of a single image acquired by the camera 502. The projected focus pattern 604 comprises one or more line patterns. The projected focus pattern 604 may also comprise a line pattern at other sides of the illumination spot 602, for example, below, above and at the right side of the illumination spot 602. Having multiple line patterns around the illumination spot may increase an accuracy of determining the distance value. In the example of Fig. 6, the projected focus pattern 604 is a line pattern, for example, with a duty cycle of 50%. Embodiments of the invention are not limited to this projected focus pattern 604 and any suitable pattern may be used.

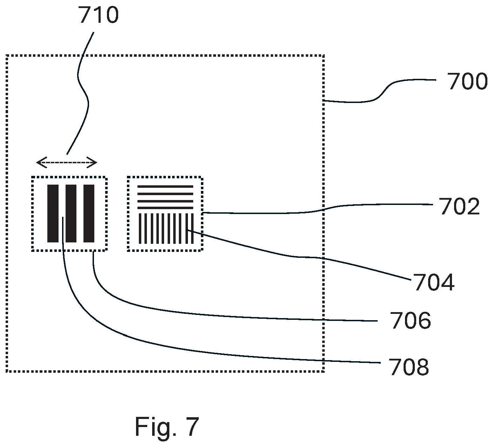

FIG. 7 shows a schematic example of a single image 700 acquired by the camera 502 of the sensor system 500. The single image 700 comprises an alignment image region 702 representing the alignment mark 522 and a focus image region 706 representing the focus pattern projected onto the substrate 518. In the illustrated embodiment, the alignment image region 702 and the focus image region 706 are spatially separated within the single image 700, such that information relating to the alignment mark 522 and information relating to the focus pattern can be obtained from different regions of the same single image 700.

The alignment image region 702 comprises an image of alignment mark 704. In the example of Fig. 7, the alignment mark on the substrate 518 comprises horizontal lines and vertical lines. In the context of this invention, other alignment marks can be used as well and the invention is not limited to the presented image of the alignment mark 704. The term alignment mark 704 can also be interpreted as 'any structure on which an alignment measurement is performed', e.g. it may also be a part of the product structures of the semiconductor device that is manufactured on the substrate. The image of alignment mark 704 may be processed to determine positional information of the alignment mark 522. The position of the alignment mark 704 within the single image 700 may be the basis for determining the positional information of the alignment mark on the substrate.

The focus image region 706 comprises an image of focus pattern 708. The example of the focus pattern 708 in Fig. 7 relates to the projected focus pattern 604 of Fig. 6. As noted earlier, other focus patterns may also be used. The image of focus pattern 708 may be processed to determine a distance value representative of a distance from the sensor system 500 to the substrate 518. In particular, the distance value may be determined based on a displacement of the focus pattern relative to an expected position within the single image 700.

The arrow 710 schematically indicates a possible displacement of the image of focus pattern 708 within the single image 700. The displacement may result from projecting the focus pattern onto the substrate 518 at an oblique angle relative to the optical axis of the sensor system 500, so that a change in distance between the sensor system 500 and the substrate 518 causes a corresponding displacement of the image of focus pattern 708 in the focus image region 706. The positional information of the alignment mark 522 and the distance value may thereby be determined from the same single image 700.

Although the processing of the single image 700 is described as a single step, it may comprise several steps that perform independent tasks. For example, the single image 700 may be split in two images of, respectively, the alignment image region 702 and the focus image region 706. Subsequently the two images may be processed independently for obtaining, respetively, the positional information and the distance value.

According to the invention, the alignment image region 702 and the focus image region 708 are separated from each other in the single image 702. In the schematic drawing of of Figures 5 and 6 the alignment field 516, 604 and the focus region 520, 602 are also spatially separated. However, it is not strictly necessary that the alignment field 516, 604 and the focus region 516, 604 arte spatially separated at the surface of the substrate 518.

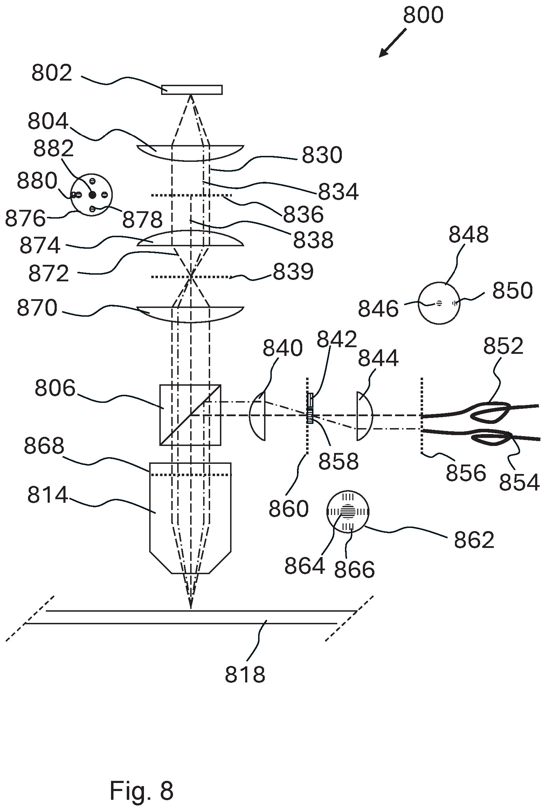

FIG. 8 shows an embodiment of a sensor system 800 configured to obtain alignment information and focus information from a substrate 818. The sensor system 800 comprises an illumination branch configured to illuminate an alignment field comprising an alignment mark on the substrate 818 and to project a focus pattern onto the substrate 818 at a focus region outside the alignment field. The sensor system 800 further comprises a detection branch configured to collect light returned from the alignment field and light returned from the focus region, and a camera 802 optically coupled to the detection branch. In the embodiment of FIG. 8, a portion of the illumination branch and a portion of the detection branch are combined along a shared optical path through an objective 814. A beam splitter 806 is arranged to combine the portion of the illumination branch and the portion of the detection branch along the shared optical path between the beam splitter 806 and the substrate 818.

The illumination branch may comprise a first light source configured to provide light for illuminating the alignment field and a second light source configured to provide light for projecting the focus pattern. The light of the first light source may have a first light characteristic and the light of the second light source may have a second light characteristic. In the illustrated embodiment, a first fiber 852 is configured to transport light from the first light source toward the illumination branch, and a second fiber 854 is configured to transport light from the second light source toward the illumination branch. A light exit window of the first fiber 852 and a light exit window of the second fiber 854 may be positioned at a pupil plane or a conjugate pupil plane 856 of the illumination branch. As indicated in the schematic cross-sectional view 848 of pupil plane or conjugate pupil plane 856, the first fiber 852 may provide illumination alignment light 846, and the second fiber 854 may provide illumination focus light 850. The illumination alignment light 846 may be provided at or near a central optical axis of the illumination branch, and thus at the center of the pupil plane or conjugate pupil plane 856. The illumination focus light 850 may be provided at a position spaced apart from the central optical axis, and, in other words, at a position spaced apart from the center of the pupil plane or the conjugate pupil plane 856. In an embodiment, the light exit window of the second fiber 854 may be positioned closer to an edge of a pupil plane or conjugate pupil plane 856 than to a center of the pupil plane or conjugate pupil plane 856, thereby providing the illumination focus light 850 off-axis so that the focus pattern is projected onto the substrate 818 at an oblique angle relative to an optical axis of the sensor system 800. Note that conjugate pupil plane 856 is conjugate to a pupil plane 868 of objective 814.

The invention is not limited to performing the alignment measurement with illumination aligment light 846 with a single first light characteristic and determining the distance value with illumination focus light 850 with a single second light characteristic. For example, in certain use cases, the alignment measurement is repeated with light of a third light characteristic, or even more different light characteristcs, to obtain more accurate positional information. In a futher example, the alignment measurement is repeated with light of different wavelengths. For example, in certain use cases, the measurement for determining the distance value can also be repeated with different light characteristics to determine a more accurate distance value.

The illumination branch comprises optical elements for directing and shaping the illumination alignment light 846 and the illumination focus light 850. A fifth lens 844 and a fourth lens 840 are arranged between the first and second fibers 852, 854 and the beam splitter 806. A first filter 858 may be arranged in the illumination branch and may be configured to shape and/or spectrally select the illumination alignment light 846. A second filter 842 may be arranged in the illumination branch and/or spectrally select the illumination focus light 850. The second filter 842 may be configured to pattern focus light, for example by defining or transmitting a structured portion of the illumination focus light 850. The second filter 842 may have a pattern of light transmitting lines. The first filter 858 and the second filter 842 may be different from one another with respect to at least one filtering characteristic. In some embodiments, at least one of the first filter 858 and the second filter 842 is a dichroic filter. As indicated above, the illumination alignment light may have first light characteristics and the illumination focus light may have second light characteristics. The first and second light characteristics may be determined by the light source. The first filter 858 and the second filter 842 may further modify the light characteristics and/or define the respective first light characteristics and second light characteristics. Additionally, or alternatively, the first light characteristic and the second light characteristic may comprise different wavelength bands or different polarizations.

If the illumination light 846 is provided by the second fiber 854, and if the diameter of the core of the second fiber 854 is chosen carefully to have a required illumination spot at substrate 818 level, then the first filter 858 may be redundant and not needed in the sensor system 800.

The illumination branch may further comprise a field stop arranged in a field plane conjugate to the focus plane of the sensor system 800, which may be, in use, the top surface of the substrate 818. In the illustrated embodiment, the conjugate field plane 860 corresponds to a location of the field stop. The cross-sectional view 862 of the conjugate field plane 860 schematically illustrates that the field stop comprises a central transmitting area 864 and a pattern of transmitting areas arranged outside the central transmitting area 864. The central transmitting area 864 is configured to define an illumination spot on the alignment field, while the transmitting pattern is configured to define the focus pattern. In the illustrated embodiment, the transmitting pattern comprises a line pattern 866. The line pattern 866 may comprise one or more line patterns, may comprise multiple line patterns arranged at different areas around the central transmitting area 864, and may have a duty cycle of about 50%. It is to be noted that the pattern may also be different and may also be located at different locations in the filed plane 860 and the pattern is not limited to line patterns. The line pattern 866 may also create first and higher diffraction orders.

The central transmitting area 864 may be configured to transmit light having a first light characteristic, and the transmitting pattern including the line pattern 866 may be configured to transmit light having a second light characteristic different from the first light characteristic. Thus, the central transmitting area 864 may pass illumination alignment light 846 used for illuminating the alignment field, while the line pattern 866 may pass illumination focus light 850 used for projecting the focus pattern. In an example, the central transmitting area 864 may be circular and may define, in use, an illumination spot having a diameter of about 250 µm at the surface of the substrate 818. In another examples, the diameter of the illumination spot is in a range from 200 to 350 micrometers. In another example, the illumination spot may be rectangular or square. The line pattern 866 may be arranged outside the central transmitting area 864 and may be oriented along an off-axis direction of the illumination focus light 850. A pitch of the line pattern 866 may be selected in a range from about 5 µm to about 50 µm at substrate level. A larger pitch may reduce spreading of an illumination pupil of the focus branch due to diffraction, and a smaller pitch may increase a number of lines available for fitting a position of the focus pattern.

The illumination alignment light 846 and the illumination focus light 850 are directed by the fourth lens 840 and the beam splitter 806 toward the objective 814. A pupil plane 868 in the objective 814 is shown schematically. The objective 814 projects the illumination alignment light 846 onto the alignment field on the substrate 818 and projects the illumination focus light 850 onto the focus region outside the alignment field as the focus pattern. Since the illumination focus light 850 is introduced off-axis, the focus pattern is projected onto the substrate 818 at an oblique angle relative to the optical axis of the sensor system 800. A change in a distance from the sensor system 800 to the substrate 818 may thereby cause a displacement of the focus pattern relative to an expected position in a single image acquired by the camera 802.

The detection branch collects light returned from the alignment field and light returned from the focus region. In the illustrated embodiment, the objective 814 collects returned alignment light and returned focus light from the substrate 818 and directs the collected light through the beam splitter 806 and a third lens 870 toward the camera 802. Assuming the alignment mark in the alignment field is a diffracting structure, for example, a grating, the returned alignment light may include a +1st diffraction order returned alignment light 830, a zeroth diffraction order returned alignment light 838, a -1st diffraction order returned alignment light 872. In a cross-sectional view 876 of the conjugate pupil plane 836, returned focus light 880 and returned alignment light 878 are schematically depicted. One of the diffraction orders 878 of returned alignment light is schematically indicated with number 878 and other diffraction orders are also schematically shown at 90 degrees rotational points around the center of cross-sectional view 876. In the pupil plane 834, a central block 882 may be present 882 that prevents the zeroth order returned alignment light 838 to continue towards the camera 802.

As discussed above, the detection branch may comprise a pupil filter provided at a pupil plane or a conjugate pupil plane of the detection branch. In the illustrated embodiment, a conjugate pupil plane 836 of the detection branch is shown between the second lens 874 and a first lens 804. The cross-sectional view 876 schematically illustrates a central block 882 for zeroth diffraction order returned alignment light 838. The central block 882 may block the zeroth diffraction order returned alignment light 838 while transmitting the +1st diffraction order returned alignment light 830 and the -1st diffraction order returned alignment light 872 (and, of course, the returned focus light 880). The detection branch may thus be configured for dark-field detection of the alignment mark. The pitch of the repetitive structure of the alignment mark may be selected such that returned alignment light 830, 872, 878 passes the central block 882.

The second lens 874, the first lens 804, and the other optical elements of the detection branch may image the returned alignment light and the returned focus light onto the camera 802. A conjugate field plane 839 of the detection branch is shown in the optical path toward the camera 802. The camera 802 may be a two-dimensional camera configured to record a two-dimensional image. The camera 802 may acquire a single image comprising an alignment image region representing the alignment mark and a focus image region representing the focus pattern, wherein the focus image region is spatially separated from the alignment image region.

The sensor system 800 may further comprise a processor configured to process the single image to determine positional information of the alignment mark and to determine a distance value representative of a distance from the sensor system 800 to the substrate 818. The processor may determine the positional information based on information present in the single image representing the alignment mark, and may determine the distance value based on information in the single image representing the focus pattern. In particular, the processor may determine the distance value based on a displacement of the focus pattern relative to an expected position within the single image. The expected position is, for example, a position of the focus pattern if the surface of the substrate 818 is exactly in focus of the sensor system 800. The displacement may be detected by fitting, by pattern recognition, or by fitting at a known period of the focus pattern. The processor may correct the positional information based on the distance value.

Where the focus pattern comprises multiple line patterns arranged at different areas around the alignment field, the processor may determine multiple distance values based on information of individual line patterns of the multiple line patterns and may interpolate the multiple distance values to obtain a single distance value at or near the alignment mark. The processor may additionally determine a tilt value for the substrate 818 based on the multiple distance values, and may correct the positional information based on the distance value and the tilt value. In an example in which the illumination focus light 850 is incident with an incident numerical aperture of about 0.45, a displacement x of the focus pattern may be approximately proportional to a defocus d according to x = tan(asin(0.45)) · d, so that the displacement x is approximately 0.5 · d. This relation is an example, and other angles of incidence may be used.

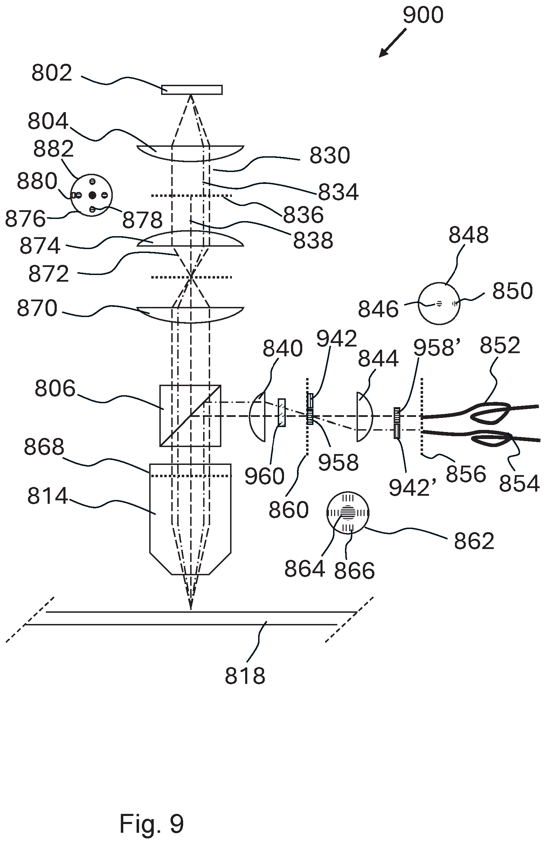

The sensor system 800 may be implemented with different light-source and filtering arrangements. In one embodiment, the first light source emitting light with a first light characteristic and the second light source emitting light of a second light characteristic, the first and second light source comprise different light emitting diodes. In another embodiment, the first light source and the second light source are formed by filtering light from a supercontinuum light source using two different filters to generate two light beams having different light characteristics. The first light characteristic may have a first wavelength and the second light characteristic may have a second wavelength different from the first wavelength. In another embodiment, the first light characteristic and the second light characteristic comprise different polarizations. For example, light for the alignment field and light for the focus pattern may be provided with orthogonal polarizations, and polarizing filters may be arranged at or near the field stop so that the central transmitting area 864 and the transmitting pattern including the line pattern 866 select different polarizations. A birefringent material may be arranged to reduce coherence between polarization components, for example before the light is projected onto the substrate 818. Further details will be discussed in the context of Fig. 9.

The focus pattern need not be limited to the illustrated line pattern 866. The focus pattern may comprise a grating, a plurality of gratings, a large-area line pattern, a plurality of discrete line patterns, or another structured pattern having a predefined structure or pitch. The focus pattern may be superposed with structures already present on the substrate 818, and may be separated from such structures using fitting or pattern recognition based on the known structure or pitch of the focus pattern. The focus pattern may be reflected from the substrate 818 without requiring diffraction by the substrate 818. Alternatively, in some embodiments, the focus pattern may interact with a bond-pad grid or another substrate structure so that the returned focus light contains height information from a layer of interest.

The sensor system 800 may be calibrated or operated to reduce height-processing-dependence. For example, a height measurement obtained from the focus pattern may be calibrated per substrate type using a different measurement, such as a through-focus scan or a contrast change measured with an alignment function. A region from which height information is extracted may be sufficiently large that focus information can be extracted from substantially the same position on the substrate 818 even when the substrate 818 is displaced by a loading uncertainty. Additional colors, including ultraviolet wavelengths, may be used to reduce sensitivity to layer-stack variations. Information from a die-level sensor, grey values, contrast values, or other image information may also be used to assist calibration for height variations.

The sensor system 800 may also comprise multiple off-axis illumination spots associated with different projected patterns. For example, respective light sources or fibers may be arranged at opposed positions in a pupil plane so that corresponding line patterns move in opposite directions as a function of defocus. The distance value may then be inferred from a relative position of the different line patterns. A zero position (earlier referred to as expected position) of the focus pattern may be set using a through-focus scan, optionally in a bright-field mode, or using a focus measurement on alignment targets. In further embodiments, the focus function may be used for particle detection by determining a local deviation in a phase map obtained from the measured focus pattern. The sensor system 800 may also be used to map substrate topography by scanning over the substrate 818 and recording height information while scanning.

FIG. 9 shows an embodiment of a sensor system 900 that may correspond generally to the sensor system 800 described with reference to FIG. 8, with the sensor system 900 being configured to distinguish, shape, or select illumination for the alignment field and illumination for the focus pattern based on polarization. Components of FIG. 9 having the same reference numerals as components of FIG. 8 may have the same or corresponding functions and will not be described again in detail. In particular, the sensor system 900 may comprise the camera 802, the first lens 804, the beam splitter 806, the objective 814, the substrate 818, the fourth lens 840, the fifth lens 844, the first fiber 852, the second fiber 854, the third lens 870, the second lens 874, and the central block 882, arranged to illuminate an alignment field, project a focus pattern at a focus region outside the alignment field, collect light returned from the alignment field and light returned from the focus region, and acquire a single image comprising a spatially separated alignment image region and focus image region.

In the embodiment of FIG. 9, the first light characteristic and the second light characteristic may comprise different polarizations. The first fiber 852 and the second fiber 854 may provide light to the illumination branch at the pupil plane or conjugate pupil plane 856. The light provided via the first fiber 852 and the light provided via the second fiber 854 may be orthogonally polarized in the pupil domain. For example, one branch may provide light having a polarization at about -45 degrees, and the other branch may provide light having a polarization at about +45 degrees. The light may be provided from two separate fibers without a pupil filter, optionally from the same light source and with the same wavelength or color. In another embodiment, light may be provided from a single fiber in combination with a pupil filter, although such an arrangement may be less photon-efficient.

The sensor system 900 comprises polarization filters for selecting the different polarizations in the illumination branch. A first polarization filter 942 and a second polarization filter 942' may be arranged in the optical path of the illumination focus light. The first polarization filter 942 is in the conjugate image plane 860 and may comprise a pattern for defining the focus pattern and only allows the transmission of light in e.g. the -45 degree polarization state. The second polarization filter 942' may be provided in between the conjugate pupil plane 856 and the fifth lens 844 and may be configured to change the polarization of light received from the second fiber 854 towards e.g. the - 45 degree state..

A third polarization filter 958 and a fourth polarization filter 958' may be arranged in the illumination branch. The third polarization filter 958 may be provided in the conjugate image plane 860, may be configured to define a size and shape of an illumination spot of the alignment field on the surface of the substrate 818 and only allows the transmission of light in e.g. the 45 degree polarization state. The third polarization filter 958 may for example have a central region where light of e.g. 45 degree polarization state can be transmitted. The fourth polarization filter 958' may be provided in between the conjugate pupil plane 856 and the fifth lens 844 and may be configured to change the polarization of light received from the first fiber 852 towards e.g. the 45 degree polarization state.

The sensor system 900 further comprises a birefringent plate 960 arranged in the illumination branch somewhere in between the conjugate image plane 860 and the beam splitter 806. The birefringent plate 960 may be configured to change the polarization state of light that has passed through the first polarization filter 942 and/or the second polarization filter 942' and/or the third polarization filter 958 and/or the fourth polarization filter 958'. The birefringent plate 960 may project orthogonal axes of the incident polarization states onto the substrate 818 at 0 degrees and 90 degrees. When the light incident on the birefringent plate 960 has polarization states at about -45 degrees and +45 degrees, the birefringent plate 960 may project the light substantially equally onto the 0 degree and 90 degree axes at the substrate 818.

The birefringent plate 960 may reduce coherence between polarization components. For example, when an LED source with a bandwidth of about 10 nm is used, a coherence length may be about 30 µm. The birefringent plate 960 may comprise a quartz plate having a thickness of about 3 mm, so that two polarization components are separated by about a multiple of the coherence length and become mutually incoherent. This may allow the sensor system 900 to use polarization to route or select the illumination alignment light 846 and the illumination focus light 850 while still providing illumination at the substrate 818 that is substantially unpolarized, or less sensitive to polarization-dependent interaction with structures or layers of the substrate 818.

The detection branch of the sensor system 900 may operate as described with reference to FIG. 8. The objective 814 may collect returned alignment light and returned focus light from the substrate 818, including the +1st diffraction order returned alignment light 830, the zeroth diffraction order returned alignment light 838, the -1st diffraction order returned alignment light 872, other returned alignment light 878, and returned focus light 834, 880. The central block 882 may block the zeroth diffraction order returned alignment light 838 and may allow dark-field detection of the alignment mark, while the returned focus light 834, 880 may be imaged onto the camera 802 at a focus image region spatially separated from the alignment image region. A processor may process the single image to determine positional information of the alignment mark and a distance value representative of a distance from the sensor system 900 to the substrate 818, and may correct the positional information based on the distance value and, where determined, a tilt value.

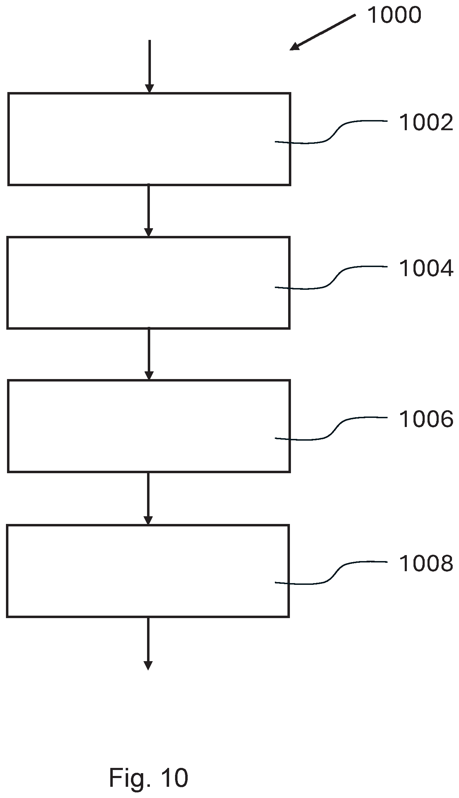

FIG. 10 shows a flowchart of a method of operating a sensor system 1000. The method 1000 may be performed using any sensor system described herein, including the sensor system 500, the sensor system 800, or the sensor system 900. At step 1002, the method 1000 comprises illuminating an alignment field comprising an alignment mark on a substrate. At step 1004, the method 1000 comprises projecting a focus pattern onto the substrate at a focus region outside the alignment field, the focus pattern being projected under an oblique angle relative to an optical axis of the sensor system. At step 1006, the method 1000 comprises collecting light returned from the alignment field and light returned from the focus region. At step 1008, the method 1000 comprises acquiring a single image comprising an alignment image region representing the alignment mark and a focus image region representing the focus pattern, the focus image region being spatially separated from the alignment image region. The single image may be processed to determine positional information of the alignment mark and to determine a distance value representative of a distance from the sensor system to the substrate, so that focus-related information and alignment-related information may be obtained from the same image.

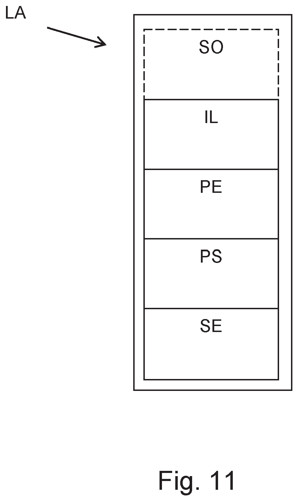

FIG. 11 schematically shows an exposure apparatus. The exposure apparatus is for example a lithographic apparatus LA. The lithographic apparatus LA may comprise a radiation source SO which is configured to generate radiation, for example DUV or EUV radiation. The lithographic apparatus LA comprises an illumination system IL which receives said radiation from the radiation source SO, e.g., via a beam delivery system to form a radiation beam. The lithographic apparatus LA further comprises a patterning environment PE in which a patterning device (e.g., a mask or a reticle) may be provided, a projection system PS, and a substrate environment SE in which a substrate (e.g., a resist coated semiconductor wafer) may be provided.

The illumination system IL is configured to condition the radiation beam before it enters the patterning environment. The illumination system IL may include various types of optical components, such as refractive, reflective, magnetic, electromagnetic, electrostatic, and/or other types of optical components, or any combination thereof, for directing, shaping, and/or controlling radiation. The illumination system IL may be used to condition the radiation beam to have a desired spatial and angular intensity distribution in its cross section at a plane of the patterning device.

After being thus conditioned, the radiation beam enters the patterning environment PE, where it may interact with the patterning device. As a result of this interaction, a patterned radiation beam is generated. The projection system PS is configured to further direct, shape, and/or control the patterned radiation beam such that it enters the substrate environment SE where it may be projected onto the substrate. The projection system PS may include various types of optical components, including refractive, reflective, catadioptric, anamorphic, magnetic, electromagnetic and/or electrostatic optical components, as appropriate for the exposure radiation being used and/or in consideration of other factors such as the use of an immersion liquid or the use of a vacuum.

The lithographic apparatus LA may have an assessment apparatus to assess a position of an alignment mark on the substrate in the substrate environment SE and to assess a height / level map of the surface of the substrate. The assessment apparatus may comprise the sensor system according to the invention.

The lithographic apparatus LA and radiation source SO described herein can be used in a method for manufacturing a semiconductor device. A semiconductor device manufacturing method comprises receiving a substrate with a photoresist layer. The method further comprises directing a radiation beam from the radiation source SO to a substrate, to transfer a pattern on the photoresist layer. The method for manufacturing a semiconductor device further comprises the step of removing a portion of the photoresist layer to form the pattern on the substrate.

Further embodiments are disclosed in the subsequent list of numbered clauses:
1. A sensor system comprising:
   an illumination branch configured to illuminate an alignment field comprising an metrology structure on a substrate, and to project a pattern onto the substrate at a pattern region outside the alignment field, the pattern being projected onto the substrate at an oblique angle relative to an optical axis of the sensor system;
   a detection branch configured to collect light returned from the alignment field and light returned from the pattern region; and
   a camera optically coupled to the detection branch and configured to acquire a single image comprising an alignment image region representing the metrology structure and a focus image region representing the pattern, the focus image region being spatially separated from the alignment image region.
2. The sensor system according to clause 1, wherein the pattern comprises one or more line patterns.
3. The sensor system according to clause 2, wherein the pattern comprises multiple line patterns arranged at different areas around the alignment field.
4. The sensor system according to clause 2 or 3, wherein the line pattern has, or the multiple line patterns have, a duty cycle of about 50%.
5. The sensor system according to any preceding clause, further comprising an objective, wherein a portion of the illumination branch and a portion of the detection branch are combined along a shared optical path though the objective, and wherein the objective is configured to illuminate the alignment field and project the pattern onto the substrate and to collect at least part of the light returned from the alignment field and from the pattern region.
6. The sensor system according to clause 5, further comprising a beam splitter configured to combine the portion of the illumination branch and the portion of the detection branch along the shared optical path between the beam splitter and the substrate.
7. The sensor system according to any preceding clause, wherein the illumination branch comprises a field stop configured to shape light used to illuminate the alignment field and to shape light used to project the pattern, the field stop being arranged in a field plane conjugate to the focus plane of the sensor system.
8. The sensor system according to clause 7, wherein the field stop comprises a central transmitting area configured to define an illumination spot on the alignment field and a transmitting pattern of transmitting areas arranged outside the central transmitting area and configured to define the pattern.
9. The sensor system according to clause 8, wherein the central transmitting area is configured to transmit light having a first light characteristic, the transmitting pattern is configured to transmit light having a second light characteristic, and the first light characteristic differs from the second light characteristic.
10. The sensor system according to clause 8 or 9, wherein at least one of: the central transmitting area comprises a first filter, and the transmitting pattern comprises a second filter, and wherein the first filter is different from the second filter with respect to at least one filtering characteristic.
11. The sensor system according to clause 10, wherein at least one of the first filter and the second filter is a dichroic filter.
12. The sensor system according to clause 9 or 10, wherein the first light characteristic and the second light characteristic comprise different wavelength bands.
13. The sensor system according to any of clauses 9 to 12, wherein the first light characteristic and the second light characteristic comprise different polarizations.
14. The sensor system according to any preceding clause, wherein the illumination branch comprises a first light source configured to provide light for illuminating the alignment field and a second light source configured to provide light for projecting the pattern.
15. The sensor system according to clause 14, wherein light of the first and second light source is received at a pupil plane or conjugate pupil plane of the illumination branch, and at least one of: the first light source provides light at the center of respective pupil plane and the second light source provides light at a position spaced apart from the center of respective pupil plane.
16. The sensor system according to clause 14 or 15, wherein the first light source and the second light source comprise different light emitting diodes.
17. The sensor system according to clause 14 or 15, wherein sensor system comprises a supercontinuum light source optically coupled to two different filters configured to generate two light beams having different light characteristics thereby forming the first light source and the second light source.
18. The sensor system according to any of clauses 14 to 17, further comprising a first fiber configured to transport light from the first light source toward the illumination branch and a second fiber configured to transport light from the second light source toward the illumination branch.
19. The sensor system according to clause 18, wherein a light exit window of the first fiber and a light exit window of the second fiber are positioned at a pupil plane or a conjugate pupil plane of the illumination branch.
20. The sensor system according to clause 19, wherein at least one of: the light exit window of the first fiber is positioned at a point that coincides with a central optical axis of the illumination branch, the light exit window of the second fiber is positioned at a distance from the central optical axis, and, optionaly, when directly or indirectly dependent on clause 5, the light exit window of the second fiber is positioned closer to the edge of the pupil of the objective than to the center of the pupil of the objective.
21. The sensor system according to any preceding clause, wherein the detection branch comprises a pupil filter provided at a pupil plane or a conjugate pupil plane of the detection branch.
22. The sensor system according to clause 21, wherein the metrology structure partially diffracts light and the pupil filter is configured to block a zeroth diffraction order of collected light associated with the alignment image region.
23. The sensor system according to any preceding clause, wherein the camera is a two-dimensional camera configured to record a two-dimensional image.
24. The sensor system according to any preceding clause, further comprising a processor configured to process the single image to determine positional information of the metrology structure and to determine a distance value representative of a distance from the sensor system to the substrate.
25. The sensor system according to clause 24, wherein the processor is configured to determine the positional information based on information present in the single image representing the metrology structure.
26. The sensor system according to clause 24 or 25, wherein the processor is configured to determine the distance value based on information in the single image representing the pattern.
27. The sensor system according to clause 26, when directly or indirectly dependent on clause 3, wherein the processor is configured to determine multiple distance values based on information of individual line patterns of the multiple line patterns and the processor is optionally configured to interpolate the multiple distance values to obtain a single distance value.
28. The sensor system according to clause 27, wherein the processor is configured to determine a tilt value for the substrate based on the determined multiple distance values.
29. The sensor system according to clause 26, 27 or 28, wherein the processor is configured to determine the distance value based on the displacement of the pattern relative to an expected position within the single image.
30. The sensor system according to any of clauses 24 to 29, wherein the processor is configured to correct the positional information based on at least one of the distance value and, optionally, when directly or indirectly being dependent on clause 28, the determined tilt value.
31. A method of operating a sensor system, the method comprising:
   illuminating an alignment field comprising an metrology structure on a substrate;
   projecting a pattern onto the substrate at a pattern region outside the alignment field, the pattern being projected under an oblique angle relative to an optical axis of the sensor system;
   collecting light returned from the alignment field and light returned from the pattern region; and
   acquiring a single image comprising an alignment image region representing the metrology structure and a focus image region representing the pattern, the focus image region being spatially separated from the alignment image region.
32. The method according to clause 31, wherein the pattern comprises one or more line patterns.
33. The method according to clause 32, wherein the pattern comprises multiple line patterns arranged at different areas around the alignment field.
34. The method according to clause 32 or 33, wherein the line pattern has, or the multiple line patterns have, a duty cycle of about 50%.
35. The method according to any of clauses 31 to 34, wherein illuminating the alignment field, projecting the pattern, and collecting the light returned from the alignment field and the light returned from the pattern region are performed through an objective of the sensor system, and wherein a portion of an illumination branch and a portion of a detection branch of the sensor system are combined along a shared optical path through the objective.
36. The method according to clause 35, wherein the portion of the illumination branch and the portion of the detection branch are combined by a beam splitter along the shared optical path between the beam splitter and the substrate.
37. The method according to any of clauses 31 to 36, wherein illuminating the alignment field and projecting the pattern comprise shaping light using a field stop of an illumination branch of the sensor system.
38. The method according to clause 37, wherein the field stop comprises a central transmitting area that defines illumination of the alignment field and a transmitting pattern of transmitting areas arranged outside the central transmitting area that defines the pattern.
39. The method according to clause 38, wherein light transmitted through the central transmitting area has a first optical characteristic, light transmitted through the transmitting pattern has a second optical characteristic, and the first optical characteristic differs from the second optical characteristic.
40. The method according to clause 39, wherein the central transmitting area comprises a first filter and the transmitting pattern comprises a second filter, the first filter differing from the second filter with respect to at least one optical filtering characteristic.
41. The method according to clause 40, wherein at least one of the first filter and the second filter is a dichroic filter.
42. The method according to clause 39 or 40, wherein the first optical characteristic and the second optical characteristic comprise different wavelength bands.
43. The method according to any of clauses 39 to 42, wherein the first optical characteristic and the second optical characteristic comprise different polarizations.
44. The method according to any of clauses 31 to 43, wherein illuminating the alignment field comprises providing light from a first light source, and wherein projecting the pattern comprises providing light from a second light source.
45. The method according to clause 44, wherein providing light from the first light source and providing light from the second light source comprises receiving light from the first light source and light from the second light source at a pupil plane or a conjugate pupil plane of an illumination branch of the sensor system, and wherein at least one of the light from the first light source is provided at a center of respective pupil plane and the light from the second light source is provided at a position spaced apart from the center of respective pupil plane.
46. The method according to clause 44 or 45, wherein the first light source and the second light source comprise different light emitting diodes.
47. The method according to clause 44 or 45, wherein the first light source and the second light source are formed by filtering light from a supercontinuum light source using two different filters to generate two light beams having different light characteristics.
48. The method according to any of clauses 44 to 47, wherein light from the first light source is transported toward an illumination branch of the sensor system through a first fiber, and light from the second light source is transported toward the illumination branch through a second fiber.
49. The method according to clause 48, wherein light exits the first fiber and the second fiber at a pupil plane or a conjugate pupil plane of the illumination branch.
50. The method according to clause 49, wherein light exits the first fiber at a point that coincides with a central optical axis of the illumination branch and exits the second fiber at a distance from the central optical axis.
51. The method according to any of clauses 31 to 50, wherein the collected light passes through a pupil filter provided at a pupil plane or a conjugate pupil plane of a detection branch of the sensor system.
52. The method according to clause 51, wherein the metrology structure partially diffracts light, and wherein the pupil filter blocks a zeroth diffraction order of collected light associated with the alignment image region.
53. The method according to any of clauses 31 to 52, wherein acquiring the single image comprises recording a two-dimensional image using a two-dimensional camera.
54. The method according to any of clauses 31 to 53, further comprising processing the single image to determine positional information of the metrology structure and to determine a distance value representative of a distance from the sensor system to the substrate.
55. The method according to clause 54, wherein determining the positional information comprises determining the positional information based on information present in the single image representing the metrology structure.
56. The method according to clause 54 or 55, wherein determining the distance value comprises determining the distance value based on information in the single image representing the pattern.
57. The method according to clause 56, when directly or indirectly dependent on clause 33, wherein determining the distance value comprises determining multiple distance values based on information of individual line patterns of the multiple line patterns.
58. The method according to clause 57, further comprising interpolating the multiple distance values to obtain a single distance value.
59. The method according to clause 57 or 58, further comprising determining a tilt value for the substrate based on the multiple distance values.
60. The method according to any of clauses 56 to 59, wherein determining the distance value comprises determining the distance value based on a displacement of the pattern relative to an expected position within the single image.
61. The method according to any of clauses 54 to 60, further comprising correcting the positional information based on the distance value.
62. The method according to clause 59, further comprising correcting the positional information based on the distance value and, optionally, the tilt value.
63. A bonding apparatus for bonding a first substrate to a second substrate, the bonding apparatus comprising:
   a positioning module for positioning the first substrate with respect to the second substrate and bonding the first substrate to the second substrate, and
   the sensor system according to any one of clauses 1 to 30, wherein the sensor system illuminates the alignment field on one of the first substrate and second substrate, and the sensor system projects the pattern on the respective one of the first substrate and second substrate.
64. An exposure apparatus for exposing a substrate, the exposure apparatus comprising the sensor system of any one of clauses 1 to 30.
65. A cluster system for manufacturing a semiconductor device comprising the bonding apparatus according to clause 63 or comprising the exposure apparatus according to clause 64.
66. Method of bonding a first substrate to a second substrate comprising:
   the method of operating a sensor system according to any one of clauses 31 to 62, wherein illuminating the alignment field comprises illuminating an alignment field on one of the first substrate and second substrate, wherein projecting the pattern comprises projecting the pattern on a respective one of the first substrate and the second substrate; and
   bonding the first substrate to the second substrate.
67. Semiconductor device manufacturing method comprising the method of bonding the first substrate to the second substrate according to clause 66.
68. A computer program product comprising instructions which, when the program is executed by a processor, cause a sensor system to carry out the steps of the method of any of clauses 31 to 62, 66, 67.
69. Semiconductor device manufactured by the semiconductor device manufacturing method according to clause 67.
70. Semiconductor device manufactured by the bonding apparatus of clause 63, the exposure apparatus of clause 64 or the cluster system according to clause 65.

Although specific reference may be made in this text to apparatuses, such as bonding apparatuses and/or metrology and inspection apparatuses and/or exposure apparatus used in the process of manufacturing semiconductor devices, the apparatuses described herein may have other applications. Possible other applications include the process of integrated optical systems, guidance and detection patterns for magnetic domain memories, flat-panel displays, liquid-crystal displays (LCDs), thin film magnetic heads, etc. Embodiments of the invention may be used in other lithographic apparatuses including electron-beam lithographic apparatuses, flat-panel display lithography apparatuses, maskless lithographic apparatuses, (nano)imprint lithographic apparatuses, interference lithography apparatuses, and x-ray lithography apparatus, operable in ambient/ (non-vacuum) and/or in (near)vacuum. Embodiments of the invention may additionally be used in other apparatuses including deposition apparatuses, etching apparatuses, and die-bonding apparatuses.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Additional objects, advantages and features of the present invention are set forth in this specification, and in part will become apparent to those skilled in the art on examination of the disclosure, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A sensor system comprising:
an illumination branch configured to illuminate an alignment field comprising an metrology structure on a substrate, and to project a pattern onto the substrate at a pattern region outside the alignment field, the pattern being projected onto the substrate at an oblique angle relative to an optical axis of the sensor system;
a detection branch configured to collect light returned from the alignment field and light returned from the pattern region; and
a camera optically coupled to the detection branch and configured to acquire a single image comprising an alignment image region representing the metrology structure and a focus image region representing the pattern, the focus image region being spatially separated from the alignment image region.

2. The sensor system according to claim 1, wherein the pattern comprises one or more line patterns.

3. The sensor system according to claim 2, wherein the pattern comprises, when projected on the substrate, multiple line patterns arranged at different areas around the alignment field.

4. The sensor system according to any preceding claim, wherein the illumination branch comprises a field stop configured to shape light used to illuminate the alignment field and to shape light used to project the pattern, the field stop being arranged in a field plane conjugate to the focus plane of the sensor system.

5. The sensor system according to claim 4, wherein the field stop comprises a central transmitting area configured to define an illumination spot on the alignment field and a transmitting pattern of transmitting areas arranged outside the central transmitting area and configured to define the pattern.

6. The sensor system according to claim 5, wherein the central transmitting area is configured to transmit light having a first light characteristic, the transmitting pattern is configured to transmit light having a second light characteristic, and the first light characteristic differs from the second light characteristic.

7. The sensor system according to any preceding claim, wherein the illumination branch comprises a first light source configured to provide light for illuminating the alignment field and a second light source configured to provide light for projecting the pattern.

8. The sensor system according to claim 7, wherein light of the first and second light source is received at a pupil plane or conjugate pupil plane of the illumination branch, and at least one of: the first light source provides light at the center of respective pupil plane and the second light source provides light at a position spaced apart from the center of respective pupil plane.

9. The sensor system according to any preceding claim, wherein the detection branch comprises a pupil filter provided at a pupil plane or a conjugate pupil plane of the detection branch.

10. The sensor system according to claim 9, wherein the metrology structure partially diffracts light and the pupil filter is configured to block a zeroth diffraction order of collected light associated with the alignment image region.

11. The sensor system according to any preceding claim, wherein the camera is a two-dimensional camera configured to record a two-dimensional image.

12. The sensor system according to any preceding claim, further comprising a processor configured to process the single image to determine positional information of the metrology structure and to determine a distance value representative of a distance from the sensor system to the substrate.

13. The sensor system according to claim 12, wherein the processor is configured to correct the positional information based on at least one of the distance value.

14. A method of operating a sensor system, the method comprising:
illuminating an alignment field comprising an metrology structure on a substrate;
projecting a pattern onto the substrate at a pattern region outside the alignment field, the pattern being projected under an oblique angle relative to an optical axis of the sensor system;
collecting light returned from the alignment field and light returned from the pattern region; and
acquiring a single image comprising an alignment image region representing the metrology structure and a focus image region representing the pattern, the focus image region being spatially separated from the alignment image region.

15. A bonding apparatus for bonding a first substrate to a second substrate, the bonding apparatus comprising:
a positioning module for positioning the first substrate with respect to the second substrate and bonding the first substrate to the second substrate, and
the sensor system according to any one of claims 1 to 13, wherein the sensor system illuminates the alignment field on one of the first substrate and second substrate, and the sensor system projects the pattern on the respective one of the first substrate and second substrate.
